(19) Europäisches Patentamt
European Patent Office
Office européen des brevets

(11) EP 2 732 293 B1

(12) EUROPÄISCHE PATENTSCHRIFT

(45) Veröffentlichungstag und Bekanntmachung des Hinweises auf die Patenterteilung:
**23.05.2018 Patentblatt 2018/21**

(21) Anmeldenummer: **12758391.2**

(22) Anmeldetag: **12.07.2012**

(51) Int Cl.:
**G01R 15/18** *(2006.01)*  **H02H 3/32** *(2006.01)*

(86) Internationale Anmeldenummer:
**PCT/DE2012/000697**

(87) Internationale Veröffentlichungsnummer:
**WO 2013/007240 (17.01.2013 Gazette 2013/03)**

(54) **VERFAHREN UND VORRICHTUNG ZUR MESSUNG ELEKTRISCHER STRÖME MIT HILFE EINES STROMWANDLERS**

METHOD AND DEVICE FOR MEASURING ELECTRIC CURRENTS BY MEANS OF A CURRENT TRANSFORMER

PROCÉDÉ ET DISPOSITIF DE MESURE DE COURANTS ÉLECTRIQUES L'AIDE D'UN TRANSFORMATEUR DE COURANT

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **14.07.2011 DE 102011107721**

(43) Veröffentlichungstag der Anmeldung:
**21.05.2014 Patentblatt 2014/21**

(73) Patentinhaber: **Ean Elektroschaltanlagen GmbH 04668 Grimma (DE)**

(72) Erfinder: **RATHSMANN, Stefan 03044 Cottbus (DE)**

(74) Vertreter: **Nourney, David Knigge Nourney Böhm Rechtsanwälte Wirtschaftsmediation Partnerschaftsgesellschaft Gohliser Straße 6 04105 Leipzig (DE)**

(56) Entgegenhaltungen:
**EP-A1- 0 284 472  WO-A2-2010/035089 DE-A1- 19 705 768**

EP 2 732 293 B1

**Beschreibung**

Technisches Gebiet

Die Erfindung betrifft ein Verfahren und eine Vorrichtung zur Messung elektrischer Ströme mit Hilfe eines Stromwandlers. Insbesondere betrifft die Erfindung ein Verfahren und eine Vorrichtung zur Messung von elektrischen Differenzströmen, die neben dem Wechselauch einen Gleichstromanteil enthalten und damit Mischströme sind.

Stand der Technik

Die Messung von Differenzströmen und/oder Fehlerströmen ist ein wichtiges Anliegen auf dem Gebiet der Sicherheitstechnik von industriellen Anlagen und elektrischen Einrichtungen, insbesondere zum Schutze des Menschen vor elektrischen Schlägen, aber auch zum Schutz von Maschinen, industriellen Anlagen und elektrischen Einrichtungen vor Fehlfunktion und Beschädigungen aufgrund unerwünschter oder fehlerhafter Stromflüsse. Ein Beispiel für das mögliche Auftreten solcher unerwünschter Stromflüsse sind die sogenannten Erdschlüsse. Bei einem Erdschluss hat ein elektrischer Leiter eine nicht beabsichtigte elektrisch leitfähige Verbindung zum Erdpotenzial, das heißt zwischen Leiter und Erdpotenzial besteht ein geringer elektrischer Widerstand. Über diesen Widerstand fließt ein elektrischer Strom, der Fehlerstrom oder Differenzstrom. Dies stellt bei Überschreiten von Grenzwerten im Betrieb der elektrischen Einrichtung eine Störung und eine große Gefährdung dar.

Zur Vorbeugung einer solchen Gefährdung werden das Vorliegen sowie die Größe von Differenzströmen oder Fehlerströmen innerhalb der Einrichtung bestimmt. Bei Fehlerstrom wird unterschieden zwischen dem glatten Gleichfehlerstrom und dem pulsierenden Gleichfehlerstrom sowie dem Wechselfehlerstrom. Zur Erfassung von Wechselfehlerstrom finden induktive Stromwandler bzw. Summenwandler ihre Anwendung. Ein induktiver Stromwandler bzw. Summenwandler weist im Allgemeinen einen ferromagnetischen Wandlerkem auf, an dem eine Wandlerspule, beispielsweise ein beschichteter Kupferdraht, als Sekundärwicklung angeordnet ist. Zur Erfassung beispielsweise eines Differenzstromes werden die Zuleitung und Rückleitung von in Frage kommenden Stromkreisen der elektrischen Einrichtung gebündelt und zusammen parallel durch einen Stromwandler hindurch geführt. Die elektrische Zuleitung und die Rückleitung bilden zusammen die Primärwicklung des Stromwandlers, wobei die Primärwicklung nicht unbedingt mehrmals oder einmal den ferromagnetischen Wandlerkern umwinden muss, sondern im Allgemeinen aus lediglich auf gerade Weise durch die Mitte des Wandlerkerns durchgesteckten Leitern bestehen kann. Dabei handelt es sich bei den einfach durchgesteckten Leiern genauer gesagt um genau eine Windung, die sich allerdings in großer Entfernung vom Wandlerkern schließt.

Bei ordnungsgemäßer Funktion der elektrischen Einrichtung, das heißt bei ausreichend großem elektrischen Widerstand zwischen elektrischen Leitern und Erdpotenzial, werden sich die Summe der Ströme in der durch den Stromwandler durchgesteckten elektrischen Zuleitung und Rückleitung aufheben und somit der Stromwandler kein Signal liefem. Bei Vorliegen von unerwünschten Stromflüssen innerhalb der elektrischen Einrichtung wird jedoch ein endlicher Differenzstrom gemessen.

Induktive Stromwandler sind wie Transformatoren lediglich für elektrische Wechselströme sensitiv, wobei ohne weitere Maßnahmen ein Gleichstrom kein geeignetes Signal liefert. Da aber in der Praxis vorwiegend auch die Messung des Gleichstromanteils des Differenzstroms von Interesse ist, beispielsweise aufgrund der erhöhten Gefahr von Gleichstrom für den Menschen, wurden verschiedene Stromwandler aufweisende Einrichtungen vorgeschlagen, welche auch in der Lage sind, neben dem Wechsel- auch den Gleichstromanteil von Differenzströmen zu messen.

Aus der DE102005028881 B4 ist ein Fehlerstromanalysator zur Erfassung von Fehlerströmen und Einrichtung mit induktiven Summenstromwandlern zur Erfassung von Wechselfehlerstrom und pulsierenden Gleichstrom bekannt, bei dem mittels Filterung und Aufspaltung des erfassten Differenzstromsignales in niederfrequenten und hochfrequente Teilsignale und deren Analyse Fehlerströme detektieren kann, die üblicherweise nicht mit derartigen induktiven Summenstromwandler erfasst werden können. Weiterhin wird eine Kalibrierung des Fehlerstromanalysators über Einspeisung eines gezielt einstellbaren und bekannten Fehlerstrom über eine zusätzliche Wicklung am Summenstromwandler vorgeschlagen. Es wird dabei aber kein glatter Gleichstrom gemessen.

Aus der DE 102 37 342 A1 ist ein Verfahren und Vorrichtung zur Fehlerstromüberwachung in Wechselstromnetzen bekannt, bei dem über Stromsensoren die Ströme erfasst und digitalisiert werden und nachfolgend der Summenstrom berechnet wird. In Abhängigkeit der Phasenlage zur Spannung erfolgt die Aufteilung des Summenstromes in Wirk- und Blindstromanteile, sodass eine frequenzabhängige Wichtung der Summenströme, die dem Fehlerwechselstrom entsprechen, möglich wird. Fehlergleichströme sind nur bei Verwendung von gleichstromfähigen Stromsensoren erfassbar. Zur Erfassung eines verhältnismäßig kleinen Differenzstroms von beispielsweise 10 A + (-9,99 A) = 10 mA werden dabei aber, um eine praktische Durchführung überhaupt erst möglich zu machen, sehr genaue und teure Stromsensoren benötigt.

Ferner sind zur Messung von Mischströmen und speziell glatter Gleichfehlerströme mit Hilfe induktiver Stromwandler sind Verfahren bekannt, die sich die Nichtlinearität zwischen magnetischer Flussdichte B und Feldstärke H gemäß der Hysterese- bzw. Magnetisierungskurve B(H) des ferromagnetischen Wandlerkerns zunutze machen. Genauer gesagt wird die Tatsache ausgenutzt, dass der Wandlerkern bei zunehmendem Strom durch die Primärleiter also zunehmender magnetischer Spannung eine Sättigung erreicht, wodurch eine Abflachung des Anstiegs der Magnetisierungskurve B(H) zu höheren Primärströmen hin und somit eine Abhängigkeit der Permeabilität von durch den Primärleiter fließenden Strom resultiert. Messungstechnisch legt dabei also der Momentanwert des vorhandenen Differenzstromes fest, welcher Punkt auf der Magnetisierungskurve des Wandlerkerns eingenommen wird, wobei der Anstieg dB/dH des auf der Magnetisierungskurve eingenommenen Punktes die differentielle Induktivität der Spule im Sekundärstromkreis des Stromwandlers bestimmt, die dann durch geeignete Schaltungen gemessen wird.

In DE19943802 bzw. EP1212821 wird das Prinzip der gesteuerten Induktivität verwendet. Änderungen der Spuleninduktivität werden dabei anhand der Verstimmung eines Resonanzkreises erkannt. In DE19943802 wird das Prinzip der Transduktorschaltung verwendet, wobei der Differenzstrom als Steuerstrom des Transduktors wirkt. Bei Auftreten eines Gleichfehlerstroms verschiebt sich die Magnetisierung des Eisenkerns, wodurch sich die Spuleninduktivität ändert. Änderungen der Spuleninduktivität werden dabei anhand der Verstimmung eines Resonanzkreises erkannt. Weitere Beispiele für die Anwendung des Prinzips der gesteuerten Induktivität werden in DE3642393 A1 und DE3543985 A1 beschrieben.

Weiter ist bekannt, eine aufgebrachte Spule als gegenkoppelndes und frequenzbestimmendes Bauelement eines Multivibrators zu verwenden. Dieser legt an die Spule eine rechteckförmige Wechselspannung derart an, dass der ferromagnetische Wandlerkern immer zwischen seinen beiden Sättigungsmagnetflüssen hin und her pendelt. Durch die Spule fließt dabei ein Magnetisierungsstrom. Bei geeigneter Form der Magnetisierungskurve des Materials des Wandlerkerns lässt sich bei einer solchen Einrichtung erreichen, dass der vom Wandlerkem durchlaufene Magnetflussbereich nahezu unabhängig vom Momentanwert des Differenzstromes ist. Daraus folgt, dass jede vom Differenzstrom über dem Wandlerkern erzeugte magnetische Spannung durch eine von der Spule erzeugte magnetische Gegenspannung kompensiert wird. Dem Magnetisierungsstrom des Multivibrators überlagert sich also ein dem Differenzstrom proportionaler Gegenstrom, der dann durch geeignete Schaltungen gemessen wird.

In DE19826410 A1 ist die Prinzipschaltung eines allstromsensitiven Differenzstromsensors dargestellt, wobei der Multivibrator mit zwei aufgebrachten Spulen realisiert ist.

In EP1267467 A2 wird eine modulierende Schwingschaltung beschrieben, bei der es sich um einen Multivibrator mit einer Spule handelt. Hier wird durch einen Widerstand im Magnetisierungsstromkreis erreicht, dass der Gegenstrom das Pulsweitenverhältnis der erzeugten rechteckförmigen Wechselspannung beeinflusst. Dabei wird in EP1267467 A2 dargelegt, dass es bei den beschriebenen Verfahren durch höherfrequente Differenzstromanteile zu einer Verletzung des Abtasttheorems von Shannon kommen kann. Gemäß der dortigen Lösung wird vorgeschlagen, die von höherfrequenten Differenzstromanteilen im Wandlerkern z.B. des Multivibrators erzeugte magnetische Spannung durch eine entgegengesetzte magnetische Spannung zu kompensieren. Die entgegengesetzte Spannung wird dabei von einer zusätzlich aufgebrachten Spule erzeugt, die mit einem weiteren, induktiv arbeitenden Stromwandler über einen Hochpass verschaltet ist. Durch diese Maßnahme werden im Multivibrator Aliasing-Effekte zwischen den höherfrequenten Differenzstromanteilen und der Multivibratorfrequenz vermieden.

Aus der DE 3534 985 A1 und der DE 3 543 948 B1 ist ein Fehlerstromschutzschalter zur Erfassung von Allstrom, bestehend aus zwei Summenstromwandlern bekannt. Dabei transformiert ein Summenstromwandler Puls-und Wechselströme und ein zweiter Summenstromwandler erfasst den Gleichstrom.

Aus der DE29705030 ist ein Fehlerstromschutzschalter zur Erfassung von Allstrom mit einem Summenstromwandler bekannt. Dabei ist ein Summenstromwandler mit zwei getrennten Auswerteschaltungen für Puls-bzw. Wechselstrom und Gleichstrom ausgeführt, wobei diese über Taktgeber oder Filter betrieben werden. Der Stromwandler wird dazu entweder abwechselnd über Zeittakte mit den Auswerteschaltungen betrieben oder ist gleichzeitig über Filter mit beiden Auswerteschaltungen verbunden.

Die EP0284472-A1 beschreibt eine Vorrichtung und ein Verfahren zur Strommessung, wobei ein auf einen magnetischen Kern eines Transformators aufgegebener magnetischer Fluss in Antwort auf die Amplitude und die Dauer von Stromkomponenten einer Sekundärspule entgegengesetzter Polarität kompensiert wird. Das Integral des Sekundärstroms ist dabei ein Maß für die Flussschwankungen des magnetischen Kerns, wobei die Dauer der positiven und der negativen Flussschwankungen verglichen wird.

Nachteilig an den bekannten Lösungen mit induktiven Stromwandlern ist, dass die Erfassung des Gleichfehlerstromes indirekt über die Auswertung des Wechselstromanteils erfolgt, indem Änderungen der Induktivität ermittelt werden. Dies führt zu einer Verkomplizierung der Auswertung und der Verschaltung. Außerdem sind erhöhte Anforderungen in Bezug auf Spulenwicklung und Kernmaterial zu erfüllen. Außerdem ist häufig der Verdrahtungsaufwand für die beschriebenen Stromwandler zur Erfassung von Mischströmen höher als zur Erfassung von Wechselströmen. In einigen Ausführungen ist ein Teil der Messelektronik im Wandlergehäuse untergebracht, was eine Stromversorgung erforderlich macht. Andere Ausführungen arbeiten mit zwei Spulen auf dem Wandlerkern und benötigen einen Vierleiteranschluß.

Insgesamt beschränkt dies alles die Möglichkeit, schon vorhandene oder in elektrischen Anlagen bereits eingebaute Stromwandler zur Erfassung von Wechselstrom auf Erfassung von Mischstrom umzurüsten.

Ferner kann eine Messung von Mischströmen im Ampere-Bereich alternativ zwar auch mit Hilfe von Hall-Elementen realisiert werden, wobei bei solchen Hallstromwandlern sich das Hallelement im Luftspalt eines ferromagnetischen Eisenkerns befindet. Ein Strom im vom Kern umfassten Primärleiter führt zu einem Magnetfluss durch das Hallelement und einer auswertbaren Hallspannungen. Häufig arbeiten Hallstromwandler nach dem Kompensationsprinzip. Dazu ist auf dem Wandlerkern eine Spule aufgebracht. Diese wird von einer mit dem Hallelement verbunden Regelschaltung derart angesteuert, dass der Magnetfluss durch das Hallelement immer gleich Null ist. Jede vom umfassten Primärleiter erzeugte magnetische Spannung wird durch eine Gegenspannung kompensiert. Der dazu nötige Gegenstrom durch die Spule ist proportional zu dem Strom der Primärleiter und ist das Ausgangssignal derartiger Wandler.

Zur Messung von Differenzströmen, die im 10mA-Bereich liegen können, sind Hallstromwandler jedoch nicht geeignet.

Aufgabenstellung

Der Erfindung liegt die Aufgabe zugrunde, ein für Mischströme geeignetes Messverfahren und eine dazugehörige Messvorrichtung zu schaffen, das mit denselben Stromwandlern arbeitet, die gewöhnlich zur Messung von Wechselfehlerströmen eingesetzt werden.

Offenbarung der Erfindung

Erfindungsgemäß werden ein Verfahren und eine dazugehörige Vorrichtung zur Messung von Strömen gemäß den unabhängigen Patentansprüchen bereitgestellt.

Eine der Erfindung zugrundeliegende, vorteilhaft umgesetzte Idee kann darin gesehen werden, das bei Hallstromwandlern angewandte Kompensationsprinzip auf induktive Stromwandler zu übertragen. Es wird daher automatisch der Magnetfluss, d.h. der mit der Spule verkettete Magnetfluss im Wandlerkern, unabhängig vom auftretenden Differenzstrom konstant gehalten und den dazu äquivalente Gegenstrom durch die Spule zu messen. Dadurch kann der Gleich- und der Wechselstromanteil des Differenzstroms anhand des Sekundärgleichstroms ermittelt werden.

Bei dem erfindungsgemäßen Verfahren wird im Sekundärstromkreis eines Stromwandlers der ohmsche Widerstand der Spule mit Hilfe eines einen negativen ohmschen Widerstand bildenden steuerbaren aktiven Zweipols kompensiert, so dass der Gleichstromanteil eines von einem Primärstrom induzierten Sekundärstroms in der Sekundärspule aufrechterhalten wird. Fernern wird zur Herstellung eines definierten magnetischen Flusses im Wandlerkern eine vorbestimmte Impulsfolge über die Spule eingekoppelt, wobei der Wandlerkern durch Anlegen eines ersten Spannungsimpulses oder eines Stromes an eine Spule des Wandlers bis zum Sättigungsfluss magnetisiert wird. Anschießen wird durch Anlegen eines weiteren Spannungsimpulses umgekehrter Polarität und definierter Spannungs-Zeit-Fläche der magnetische Fluss wieder reduziert.

Es wird auch eine Vorrichtung zur Messung elektrischer Ströme geschaffen, die zum Koppeln mit den sekundären Klemmen der Spule eines Stromwandlers und, in Verbindung mit dem Stromwandler, zur Durchführung des erfindungsgemäßen Verfahrens eingerichtet ist.

Ferner wird ein System zur Messung elektrischer Ströme bereitgestellt, das einen Stromwandler und die erfindungsgemäße Vorrichtung aufweist.

Anschaulich gesagt wird gemäß einem erfinderischen Prinzip durch eine elektronische Schaltung ein aktiver Zweipol gebildet, der in Bezug auf Spannung und Strom das Verhalten eines negativen, ohmschen Widerstandes aufweist, wobei dieser Zweipol mit der Spule verbunden und so bemessen und über das Messsignal geregelt wird, dass der Betrag seines negativen Widerstandes dem ohmschen Spulenwiderstand $Rcu$ entspricht. Der ohmsche Gesamtwiderstand Sekundärstromkreis $Rg$ aus der Reihenschaltung von Spule und Zweipol wird dadurch Null. Durch diese Widerstandkompensation verhält sich die Spule auf dem Kern quasi wie ein idealer Leiter und wirkt jeder zeitlichen Änderung des mit ihr verketteten Magnetflusses entgegen.

Die Wirkung der Erfindung kann anhand der Formel, die den zeitlichen Verlauf eines Gleichstromes in einem Stromkreis aus einer Induktivität und einem ohmschen Widerstand, diskutiert werden. Für den Sekundärstromkreis hat die Formel die folgende Gestalt:

$$Is(t) = Is_0 \cdot e^{-\frac{t}{T}} \quad \text{mit} \quad T = \frac{Ls}{Rg} \quad \text{und} \quad Rg = Rcu + Rz \qquad (1)$$

Dabei ist $Is_0$ der Anfangswert des Sekundärgleichstromes, $Ls$ die Spuleninduktivität, $Rcu$ der ohmsche Widerstand der Sekundärspule, $Rz$ der negative Zweipolwiderstand und $T$ die Zeitkonstante des Stromkreises. Durch die erfindungsgemäße Widerstandskompensation geht der ohmsche Gesamtwiderstand Sekundärstromkreis $Rg$ gegen Null und damit die Zeitkonstante T gegen unendlich, sodass die Exponentialfunktion bei endlich großer Zeit t den Wert 1 behält. Da die Induktivität Teil eines Transformators ist und daher eine induktive Kopplung mit den vom Wandlerkern umfassten Primäreitern besteht, handelt es sich bei dem Anfangswert des Sekundärgleichstromes Is0 um den transformierten Differenzstrom. Ist also zunächst Is = 0 und beginnt dann ein Differenzgleichstrom zu fließen, entsteht ein Sekundärgleichstrom, der wegen der unendlichen Zeitkonstante nicht abfällt.

Mittels der beschriebenen erfindungsgemäßen Widerstandskompensation kann vorteilhaft zuverlässig gewährleistet werden kann, dass aus dem gemessenen Sekundärstrom des Stromwandler der korrekte Betrag des tatsächlichen, dem Mischstrom der Primärleiter entsprechenden, Sekundärgleichstrom bzw. Gegenstrom ermittelt werden kann.

Dies wird insbesondere durch die erfindungsgemäße Impulsfolge von Spannungsimpulsen erreicht, die über die Spule während periodischer Messpausen eingekoppelt wird. Es wird durch die Impulsfolge ein definierter magnetischer Fluss im Wandlerkern hergestellt, indem an die Spule zunächst eine Gleichspannung in Form eines Spannungsimpuls solange angelegt wird, bis der Wandlerkern sicher seinen Sättigungsmagnetfluss bzw. Sättigungsfluss erreicht hat, womit dann ein Referenzpunkt zur Verfügung steht, da in Sättigung die Magnetisierungskurve des Kernmaterials sehr flach verläuft (dB/dH gering) und der Sättigungsfluss somit nahezu unabhängig vom Differenz- und Sekundärstrom ist. Erfindungsgemäß wird dann von diesem Referenzpunkt zuzüglich geringer Zeitverzögerung ausgehend mittels Anlegens eines Spannungsimpulses umgekehrter Polarität und definierter Spannungs-Zeit-Fläche ein definierter Magnetfluss hergestellt, wodurch ein Restmagnetfluss zur Verfügung gestellt wird. Das erfindungsgemäße Verfahren wird daher unabhängig von dem Startzeitpunkt, und damit erst praktisch anwendbar gemacht: Denn die Widerstandkompensation muss zu irgendeinem Zeitpunkt aktiviert werden, an dem bereits ein Differenzstrom fließen kann, beispielsweise der Zeitpunkt des Gerätestarts der erfindungsgemäßen Vorrichtung. Von diesem Zeitpunkt an bliebe bei alleiniger Anwendung der Widerstandskompensation der Magnetfluss im Wandlerkern zwar konstant, wäre aber unbekannt. Genauer gesagt entspräche im weiteren Verlauf der Sekundärstrom nicht unbedingt genau dem. interessierenden Gegenstrom, der die magnetische Gegenspannung zum Differenzstrom erzeugt. Vielmehr ist der Sekundärstrom die Summe aus dem Gegenstrom und einem Magnetisierungsgleichstrom, der den bestehenden Magnetfluss gegen den magnetischen Widerstand des Kernes aufrechterhält.. Gemäß der Erfindung ist dieser Magnetisierungsgleichstrom dem Restmagnetfluss, d.h. dem definiert hergestellten Magnetfluss zugeordnet und wird im Folgenden als Reststrom bezeichnet.

Dabei ist die Erfindung geeignet zur Messung Mischströmen hoher Amperezahl als auch im Bereich von beispielsweise weniger als 10 mA. Ein Fachmann erkennt, dass die Erfindung vorteilhaft bei einer großen Zahl von unterschiedlichen Wandlern anwendbar ist. Insbesondere ist die Erfindung bei Standardwandlern für die Differenzstrommessung anwendbar, die gewöhnlich einen Kern aus einem hochpermeablem, weichmagnetischen Material und eine Sekundärspule mit 500 bis 1000 Windungen mit Zweileiteranschluß aufweisen. Diese werden von vielen Herstellern in den unterschiedlichsten Bauformen angeboten, so dass ein großes Sortiment zur Verfügung steht. In elektrischen Anlagen sind häufig bereits Einrichtungen zur Überwachung von Wechselfehlerströmen vorhanden, die man unter Beibehaltung der Standardwandler mit geringem Aufwand zu Überwachung und Erfassen von Mischströmen erweitern könnte. Somit führt die Erfindung zu Kostensenkungen und ermöglicht letztlich einen breiteren Einsatz von Überwachungen von Netzen mit technisch bedingt zunehmenden Anteil von Mischströmen.

Vorteilhafte Ausführungsformen der Erfindung ergeben sich aus der Beschreibung und den beigefügten abhängigen Ansprüchen.

Gemäß einer Ausführungsform der Erfindung wird die Spannungs-Zeit-Fläche des weiteren Spannungsimpulses derart gewählt und auf dem weiteren Spannungsimpuls folgend ein definierter dritter Spannungsimpuls mit zu dem weiteren Spannungsimpuls umgekehrter Polarität angelegt, dass im Wandler ein Arbeitspunkt erreicht wird, bei dem mit einem im Verhältnis zum Sättigungsstrom kleinem Magnetisierungsstrom die differentielle Induktivität des Wandlers möglichst groß ist.

Somit wird eine Entmagnetisiersequenz gefahren, mit der aufgrund der drei speziellen Spannungsimpulse eine optimale Einstellung von Reststrom und Restmagnetfluss erreicht wird. Dadurch kann die Messempfindlichkeit weiter gesteigert werden.

Gemäß einer Weiterbildung der Erfindung wird der Magnetisierungsstrom, der dem hergestellten definierten magnetischen Fluss in der Spule entspricht, auf eine Weise bestimmt, indem die Impulsfolge mit einer vorbestimmten Frequenz abwechselnd, mit jeweils umgekehrten Vorzeichen, für beide Sättigungspolaritäten angelegt wird. Daraufhin wird die Amplitude des entstehenden rechteckförmigen Magnetisierungswechselstromes ermittelt.

Damit wird das Verfahren auf günstige Weise mehrmals hintereinander angewandt und es kann die Messgenauigkeit erhöht werden, Dies wird auch begünstig dadurch, dass aufgrund der angewandten Frequenz definierte Intervalllängen vorliegen. Darüber hinaus werden Daten mit sowohl positiver als auch negativer Polarität gewonnen, was die insgesamt erreichbare Genauigkeit weiterhin erhöht.

Bevorzugt werden periodisch Messzyklen mit einer Zykluszeit gebildet, die in jeder Periode ein Zeitintervall mit Entmagnetisierungszeit und ein Zeitintervall mit Messzeit aufweist.

Gemäß einer vorteilhaften Ausführungsform der Erfindung wird ein Messsignal ermittelt, das wahlweise aus dem Verlauf des in dem Sekundärkreis des Wandlers fließenden elektrischen Stromes oder aus einem Spannungsabfall im Sekundärkreis des Wandlers entnommen wird.

Dadurch können vorteilhaft weitergehende Signalinformation bereitgestellt werden, die beispielsweise auf ihren zeitlichen Verlauf hin untersucht werden, was das Messergebnis verbessert.

Das Messsignal kann beispielsweise mittels eines Filters ermittelt bzw. erzeugt werden.

Gemäß einer Weiterbildung dieser vorteilhaften Ausführungsform wird Amplitude des entstehenden rechteckförmigen Magnetisierungswechselstromes ermittelt und ein Korrektursignal erzeugt werden, das in Verlauf und Amplitude einem rechteckförmigen Magnetisierungswechselstrom entspricht, und das Messsignal kann durch Subtraktion des ermittelten Korrektursignals entsprechend korrigiert wird.

Dadurch kann auf günstige Weise erreicht werden, dass das Verfahren weitestgehend unabhängig von einer Exemplarstreuung, einer Temperaturabhängigkeit der Wandlerkerne, usw. durchgeführt wird. Da nämlich während der Strommessung der Reststrom explizit bestimmt wird, wird der systematische Fehler verringert. Als Ergebnis dieser Reststromkompensation bleibt der reine Gegenstrom übrig, der dann einer Effektivwertbildung oder einer anderen Verarbeitung zugeführt werden kann.

Bei dieser Weiterbildung wird ausgenutzt, dass wenn die erfindungsgemäße Entmagnetisiersequenz abwechselnd und zyklisch mit positiver und negativer Sättigung durchlaufen wird, aufgrund der Symmetrie der Magnetisierungskurve nach beiden Entmagnetisiersequenzen der gleiche Reststrom aber mit umgekehrtem Vorzeichen verbleibt. Genauer gesagt erscheint in dem zeitlichen Verlauf des Sekundärstromes ein rechteckförmiger Magnetisierungswechselstrom mit Zyklusfrequenz fz, der dem vom Differenzstrom erzeugten Gegenstrom überlagert ist. Dessen Amplitude kann zum Beispiel auf einfache Weise durch eine Korrelation des Sekundärstromes mit einem zyklusfrequenten und zyklussynchronen Sinussignal ermittelt werden.

Gemäß einer Ausführungsform der Erfindung wird ein Messsignal für eine weitere Verarbeitung bereinigt derart, dass Zeitintervalle in dem Messsignal, die einem Zeitintervall der vorbestimmten Impulsfolge entsprechen, mit einem vorbestimmten konstanten Wert, insbesondere mit dem Wert Null, versehen werden.

Bei dieser vorteilhaften Ausführungsform wird die erreichbare intrinsische Genauigkeit erhöht, da Effekte die sich aus dem vorgegebenen Verlauf der Impulse ergeben, aber nichts zur Messung des interessierendes Gegenstromes beitragen sondern vielmehr stören, weitgehend entfernt werden.

Das bereinigte Messsignal kann mit einer Fensterfunktion, insbesondere einem zyklusfrequenten und zyklussynchronen Sinussignal, multipliziert werden.

Dadurch können vorteilhaft steile Flanken in dem Messsignal reduziert oder vermieden werden, und die Amplitude von Oberschwingungen hoher Ordnung auf einen kleinen Wert verringert werden, was bei der Auswertung der Messung des Mischstroms gewöhnlich eine starke Vereinfachung mit sich bringt.

Gemäß einer anderen vorteilhaften Weiterbildung wird die Größe des erzeugten negativen ohmschen Widerstands anhand einer ermittelten unvollständigen Kompensation bzw. Überkompensation des ohmschen Widerstands der Sekundärspule geregelt.

Somit können selbst geringe zeitliche Magnetflussänderungen, die über die Zeit jedoch eine erhebliche Abweichung von dem bei Aktivierung der Widerstandskompensation vorliegenden Magnetisierungsstrom verursachen können, erkannt und bei der Berechnung des interessierenden Differenzgleichstromes berücksichtigt werden. Die Zuverlässigkeit des Verfahrens wird daher noch erhöht, da selbst bei einer in der Praxis nicht exakt arbeitenden Widerstandskompensation dennoch ein konstanter Magnetisierungsstrom erzielbar ist.

Bevorzugt wird eine unvollständige Kompensation oder Überkompensation des ohmschen Widerstands der Sekundärspule ermittelt wird, indem aus dem Messsignal die Amplitude einer Harmonischen ermittelt wird, die bei Abweichung eines rechteckförmigen Magnetisierungswechselstromes von einer rechteckförmigen Signalform auftritt.

Damit wird eine Verarbeitung und Berechnung des Messergebnisses mittels eines Prozessors besonders begünstigt.

Der zu messende Strom kann nunmehr vorteilhaft aus dem Messsignal und der ermittelten unvollständigen Kompensation oder Überkompensation bestimmt wird.

Gemäß noch einer vorteilhaften Weiterbildung der Erfindung wird eine im Sekundärkreis auftretende, insbesondere durch verwendete elektronische Bauteile verursachte Offsetspannung ermittelt und anschließend kompensiert.

Damit wird ermöglicht, auch die Temperaturabhängigkeit und Exemplarstreuungen von den elektronischen Bauteilen der erfindungsgemäßen Vorrichtung zu kompensieren, und eine exakte Verarbeitung wird zugelassen und begünstigt:

So wird der Sekundärstromkreis aus der Spule und verschiedenen elektronischen Schaltungen gebildet, wobei von diesen Schaltungen verlangt wird, dass sie Gleichsignale exakt verarbeiten können. Fließt ein Sekundärstrom durch den Zweipol wird verlangt, dass dieser einen dem Sekundärstrom proportionalen Spannungsabfall ausbildet, was unter anderem bedeutet, dass der Spannungsabfall gleich Null wird, wenn der Sekundärstrom gleich Null ist. Eine exakte Gleichsignalverarbeitung ohne eine entsprechende Kompensierung führt jedoch in der Praxis oft zu Schwierigkeiten zum Beispiel aufgrund von Toleranzen bzw. der Exemplarstreuung und Temperaturabhängigkeiten aktiver, elektronische Bauelemente. Bei Operationsverstärkern, mit denen die Schaltungen des Sekundärstromkreises vorteilhaft realisiert werden, äußert sich dieses Problem in Form der Offset-Spannung. Diese Spannung ist von Exemplar zu Exemplar verschieden und ist temperaturabhängig. Eine Offset-Spannung bei den Operationsverstärkern des Zweipols führt dazu, dass dem stromproportionalen Spannungsabfall über dem Zweipol eine kleine, unerwünschte Gleichspannung überlagert ist. Die Spannungsquelle und die Stromerfassung bringen aus dem gleichen Grund ebenfalls unerwünschte Gleichspannungen in den Sekundärstromkreis ein. Diese werden nunmehr erfindungsgemäß vorteilhaft kompensiert.

Es wird bevorzugt, dass der Wert der Offsetspannung mittels Korrelation ermittelt wird, indem aus dem Messsignal die Amplitude einer Harmonischen ermittelt wird, die weder in einem rechteckförmigen Signal noch in einem doppelsägezahnförmigen Signal vorkommt.

Damit wird die Offsetspannung auf günstige Weise beispielsweise mittels eines Prozessors ermittelbar.

Gemäß einer vorteilhaften Ausführungsform ist die Magnetspule zum Geben der vorbestimmten Impulsfolge über den Wandlerkern die Sekundärspule des Wandlers.

Damit kann auf kostengünstige Weise die Messung des Mischstromes mit nur einer Spule neben dem Primärstromleiter erreicht werden. Dabei wird die Sekundärspule sowohl zur Erzeugung der Impulsfolge als auch für die Widerstandskompensierung verwendet.

Alternativ wird die Erfindung auf einen Wandler mit zusätzlichen Spulen angewandt. In noch einer anderen Ausführungsform werden mehrere Stromwandler mit jeweils einer oder mehreren Wicklungen eingesetzt, wodurch vorteilhaft die Redundanz und die Sicherheit weiter erhöht werden. Es kann beispielsweise eine andere Wicklung erfindungsgemäß verwendet werden und die vorbestimmte Impulsfolge geben, wohingegen die Sekundärwicklung für Messungen verwendet wird.

In einer Ausführungsform der Erfindung weist die Vorrichtung mindestens eine steuerbare Spannungsquelle und mindestens eine Stromerfassung auf, die mit einer Steuerung verbunden sind.

Ferner hat die Vorrichtung bevorzugt einen Regler zur Widerstandskompensation zum Anpassen des negativen Widerstandswertes des Zweipols in Abhängigkeit von der Temperatur.

In einer besonders vorteilhaften Ausführungsform ist die Steuerung mit einem Mikrocontroller implementiert.

Dabei kann die Erfindung kostengünstig und darüber hinaus klein und kompakt ausgeführt sein, da die Verarbeitung ausschließlich mittels Software oder Firmware unter Verzicht auf größerer elektronische Module erfolgt.

Erfindungsgemäß wird auch ein Verfahren zur Messung von elektrischer Strömen mit Hilfe eines Stromwandlers mit den folgenden Schritten bereitgestellt: Erweitern der Schaltung des Sekundärkreises des Stromwandlers mit einer elektrischen Vorrichtung, so dass ein einen negativen ohmschen Widerstand bildender aktiver Zweipol und eine Stromerfassung im Sekundärkreis des Wandlers in Reihe geschaltet wird, und eine Spannungsquelle im Stromkreis einer Magnetspule des Wandlers in Reihe geschaltet ist, und eine Steuereinheit mit der Stromerfassung und mit der Spannungsquelle verbunden ist; Auslesen der Stromerfassung sowie Ansteuern der Spannungsquelle mittels der Steuereinheit, zur Ausführung des erfindungsgemäßen Verfahrens; und Ausgeben eines Ausgangssignals von der Steuereinheit, das den Gleichstromanteil sowie den Wechselstromanteil eines elektrischen Primärstromes des Wandlers enthält.

Die Erfindung kann auf allen technischen Anwendungsgebieten eingesetzt werden, bei denen Mischströme gemessen werden. Sie ist zwar insbesondere vorteilhaft geeignet zur Messung von Differenzströmen oder Fehlerströmen in einer elektrischen Vorrichtung, die neben einem Wechsel- auch einen Gleichstromanteil enthalten. Dies soll jedoch keine Beschränkung des Anwendungsbereichs der Erfindung darstellen.

Zeichnungen

Im Folgenden wird die Erfindung unter Bezugnahme auf die beigefügten Zeichnungen ausführlich beschrieben. Es zeigen:

Fig. 1      eine Schaltskizze eines Stromwandlers in Verbindung mit der erfindungsgemäßen Widerstandskompensation,

Fig. 2      eine idealisierte Magnetisierungskurve,

Fig. 3      ein Strom-Zeit-Diagramm des Verlaufs eines Sekundärstromes über einen Messzyklus gemäß einer Ausführungsform der Erfindung,

Fig. 4      ein Spannungs-Zeit-Diagramm des Verlauf eines Spulenspannung über einen Messzyklus, gemäß der in Fig. 3 gezeigten Ausführungsform,

Fig. 5      eine Magnetisierungskurve mit Remanenz, mit der Impulsfolge gemäß einer anderen Ausführungsform der Erfindung.

Fig. 6      den zeitlichen Verlauf eines rechteckförmigen Ausschnittsignals gemäß einer Ausführungsform der Erfindung,

Fig. 7    den zeitlichen Verlauf einer zyklusfrequenten und zyklussynchronen Fensterfunktion gemäß der in Fig. 6 gezeigten Ausführungsform,

Fig. 8    ein lückendes Sinussignal gemäß der in Fig. 6 und Fig. 7 gezeigten Ausführungsform,

Fig. 9    ein Strom-Zeit-Diagramm des Sekundärstroms bei exakter Widerstands- und Offsetkompensation, wobei der Gegenstrom als Null angenommen wird gemäß einer Ausführungsform der Erfindung,

Fig. 10   ein Strom-Zeit-Diagramm des Sekundärstroms bei Fehlkompensation des Spulenwiderstandes gemäß einer Ausführungsform der Erfindung,

Fig. 11   ein Strom-Zeit-Diagramm eines doppelsägezahnförmigen Signals bei Fehlkompensation des Spulenwiderstandes gemäß der in Fig. 10 gezeigten Ausführungsform,

Fig. 12   ein Strom-Zeit-Diagramm eines sägezahnförmigen Signals bei Fehlkompensation der Offsetspannung gemäß einer Ausführungsform der Erfindung,

Fig. 13   ein Blockschaltbild der erfindungsgemäßen Vorrichtung zur Durchführung des Verfahrens gemäß einer Ausführungsform,

Fig. 14   eine bevorzugte Ausführungsform der erfindungsgemäßen Vorrichtung, und

Fig. 15   eine detailliertere Ansicht der erfindungsgemäßen Widerstandskompensation mit aktivem Zweipol gemäß einer Ausführungsform der Erfindung.

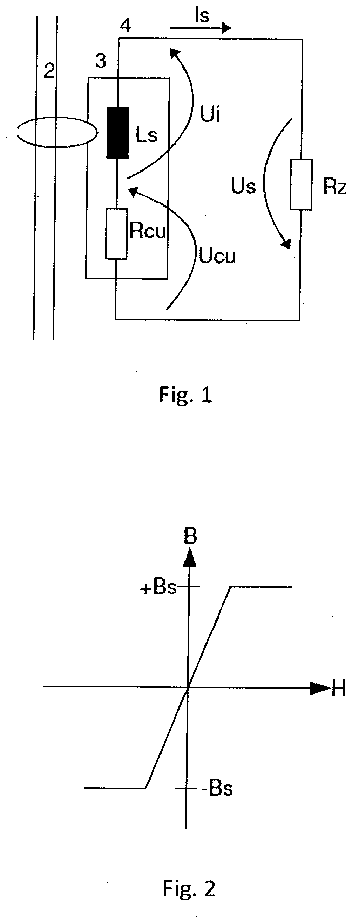

In Fig. 1 wird die Schaltskizze eines Stromwandlers mit der erfindungsgemäßen Widerstandskompensation gemäß einer Ausführungsform der Erfindung gezeigt. Die Spule 3 weist eine Spuleninduktivität Ls und einen Spulenwiderstand Rcu auf. Der Stromwandler überwacht die Primärleiter 2 auf das Vorliegen eines Differenzstromes. In dem Sekundärstromkreis 4 fließt der Sekundärstrom Is. Der Spannungsabfall Us der Spule setzt sich zusammen aus der Induktionsspannung Ui und dem Spannungsabfall Ucu über dem ohmschen Spulenwiderstand. Zur Differenzstrommessung mit Hilfe des Stromwandlers wird im Sekundärstromkreis 4 der ohmsche Spulenwiderstand Rcu der Spule 3 mit Hilfe eines einen negativen ohmschen Widerstand Rz bildenden aktiven Zweipols kompensiert. Auf diese Weise wird ein Gleichstromanteil eines von einem Primärstrom 2 induzierten Sekundärstroms Is in der Spule 3 aufrechterhalten.
Nach dem Maschensatz gilt für die Summe aller Teilspannungen in Fig. 1:

$$0 = Ui + Ucu + Us$$
$$0 = Ui + Rcu \cdot Is + Rz \cdot Is \qquad (1)$$

Dabei ist die Induktionsspannung Ui die in der Spule induzierte Spannung, Us die Spulenspannung und Is der Sekundärstrom. Aufgrund der Widerstandskompensation ist Rz = -Rcu. Daraus folgt:

$$0 = Ui \qquad (2)$$

Die induzierte Spannung ist also unabhängig vom Sekundärstrom gleich Null. Aus dem Induktionsgesetz folgt dann für die zeitliche Änderung des mit der Spule verketteten Magnetflusses $\phi$:

$$-\frac{d\phi}{dt} = Ui = 0 \qquad (3)$$

Der die Spule durchsetzende Magnetfluss wird also unabhängig vom Sekundärstrom Is und damit auch unabhängig vom Differenzstrom konstant gehalten. Ist wiederum der Magnetfluss konstant, muss die Summe der über dem Kern erzeugten magnetischen Spannungen konstant sein. Daraus folgt, dass jeder Änderung des Differenzstromes eine proportionale Änderung des Sekundärstromes Is gegenübersteht. In dem speziellen Fall, dass der Magnetfluss den Wert Null hat, ergeben sich die gleichen Verhältnisse wie am Kompensationshallstromwandler. Jeder Differenzstrom und insbesondere Gleichstrom hat einen proportionalen Gegenstrom durch die Spule zur Folge.

In Fig. 2 ist eine bekannte idealisierte Magnetisierungskurve ohne Hysterese mit idealer Sättigung dargestellt. Darin ist das Kernmaterial frei von Remanenz und weist zwischen den beiden Sättigungsflussdichten eine konstante Permeabilität auf. Bei Erreichen der Sättigung wird die Permeabilität sprunghaft Null. Diese Magnetisierungskurve wird den im Folgenden dargestellten zeitlichen Verläufen zugrunde gelegt.

Es wird eine Entmagnetisiersequenz durchfahren, so dass ein definierter magnetischer Fluss im Wandlerkern hergestellt wird. Dazu wird während jeder Entmagnetisiersequenz eine vorbestimmte Impulsfolge über den Wandlerkern gegeben. In dieser Impulsfolge wird der Wandlerkern durch Anlegen eines Spannungsimpulses oder eines Stromes an die Spule des Wandlers bis zum Sättigungsfluss magnetisiert. Anschließend wird der magnetische Fluss durch Anlegen eines zweiten Spannungsimpulses umgekehrter Polarität und definierter Spannungs-Zeit-Fläche der magnetische Fluss wieder reduziert.

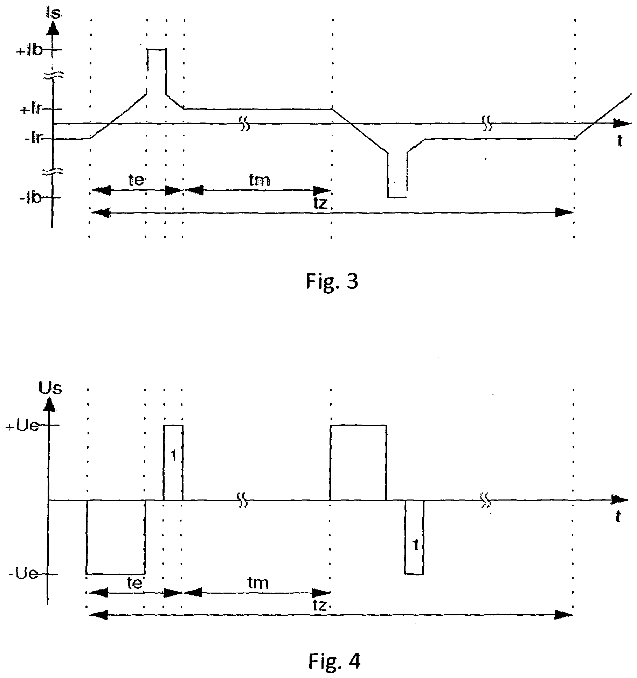

Ein einfaches Beispiel für eine erfindungsgemäße Zykluszeit mit symmetrisch periodischen Entmagnetisiersequenzen mit Entmagnetisierzeit te und Messsequenzen mit Messzeit tm wird im Folgenden unter Bezugnahme auf die Fig. 3 bis Fig. 4 beschrieben. In der vorliegenden ausführlichen Beschreibung wird zunächst der einfachen Darstellung wegen von einem idealisierten Magnetsierungskurve ausgegangen B(H), wie sie in Fig. 2 gezeigt ist. Darin ist das Kernmaterial frei von Remanenz und weist zwischen den beiden Sättigungsflussdichten Bs eine konstante Permeabilität auf. Bei Erreichen der Sättigung Bs wird die Permeabilität sprunghaft Null.

In Fig. 3 ist der Verlauf des Sekundärstromes Is über einen kompletten Messzyklus der Zykluszeit r tz, bestehend aus den Entmagnetisiersequenzen der Entmagnetisierzeit te und den dazwischen liegenden Messintervallen der Messzeit tm, dargestellt. Fig. 4 zeigt den Verlauf der Spulenspannung Us über einen Messzyklus. Der Differenzstrom und damit der Gegenstrom werden als null angenommen, sodass Sekundärstrom und Magnetsierungsstrom gleich sind. Wegen der einfacheren Darstellung liegt den Verläufen die idealisierte Magnetisierungskurve nach Fig. 2 zugrunde.

Die positive Entmagnetisiersequenz, bei der der Kern mit positivem Sekundärstrom gesättigt wird, beginnt mit dem Anlegen des ersten Spannungsimpulses 44 mit negativer Entmagnetisierspannung -Ue an die Spule. Ausgehend vom negativen Reststrom -Ir steigt der Sekundärstrom linear an. Ist der Sättigungsfluss im Wandlerkern erreicht, wird die Induktivität der Spule gleich Null. Der Sekundärstrom steigt sprunghaft bis zu einem Maximalwert +Ib an, der von einer elektronischen Strombegrenzung vorgegeben wird. Die Spulenspannung sinkt wegen der fehlenden Selbstinduktion sprunghaft von -Ue auf Null ab. Während des folgenden weiteren Spannungsimpulses mit positiver Entmagnetisierspannung +Ue und definierter Spannungs-Zeit-Fläche 1 sinkt der Sekundärstrom linear bis zum positiven Reststrom +Ir ab. Die Widerstandskompensation hält im nachfolgenden Messintervall mit Messzeit tz den Sekundärstrom auf dem Wert +Ir konstant. Es folgt die negative Entmagnetisiersequenz, die mit dem Anlegen des ersten Spannungsimpulses 44 mit positiver Entmagnetisierspannung +Ue mit +Ir beginnt und mit -Ir endet.

Die Entmagnetisiersequenz kann einmalig an den verwendeten Stromwandlertyp angepasst werden. Bei gegebener Entmagnetisierspannung Ue ist dazu die Dauer des ersten und zweiten Spannungsimpulses festzulegen. Folgende Richtwerte haben sich bewährt als eine Faustregel für Impulszeiten:

$$t_1 = \frac{2\phi_S}{Ue} \qquad t_2 = \frac{\phi_S}{2 \cdot Ue} \qquad\qquad (4)$$

Dabei ist t1 die Dauer des ersten Spannungsimpulses, t2 die Dauer des zweiten Spannungsimpulses und $\phi_s$ der Sättigungsfluss des Stromwandlers. Der Sättigungsfluss hängt von Kernmaterial, Windungszahl und Kernquerschnitt (Eisenquerschnitt) ab und kann elektronisch ermittelt werden.

Bei der obigen Beschreibung der Entmagnetisiersequenz wurde wegen der einfacheren Darstellung von der idealisierten Magnetisierungskurve des Kernes nach Fig. 2 ausgegangen. In der Praxis weisen auch die für Differenzstromwandler verwendeten, weichmagnetischen Kernmaterialen eine gewisse Koerzitivfeldstärke auf. Diese Tatsache wirkt sich auf den Verlauf des Magnetisierungsstromes während der Entmagnetisiersequenz aus. Durchläuft der Magnetfluss im Wandlerkern den Wert Null ist der Magnetisierungsstrom nicht wie nach Fig. 2 gleich Null, sondern entspricht dem Koerzitivstrom. Auch im Reststrom, der am Ende der Entmagnetisiersequenz verbleibt, ist ein Anteil des Koerzitivstromes enthalten. Der Reststrom hängt also neben der Spannungs-Zeit-Fläche der Entmagnetisiersequenz auch vom Koerzitivstrom des jeweiligen Stromwandlers ab. Neben dem Kernmaterial hat auch die Länge (Eisenweg) des Wandlerkerns Einfluss auf den Koerzitivstrom. Wegen der Längenabhängigkeit weisen z.B. Stromwandler mit großem Durchmesser oft größere Koerzitivströme auf als kleine Stromwandler. Liegt der wandlertypische Koerzitivstrom deutlich (Faktor 2) über dem gewünschten Reststrom, lässt sich der gewünschte Reststrom allein über die Spannungs-Zeit-Fläche der Entmagnetisiersequenz nur einstellen, indem ein Restmagnetfluss nah dem Sättigungsfluss gewählt wird. Da sich der Anstieg dB/dH der Magnetisierungskurve in diesem Bereich bereits verringert, steht im Messintervall nach der Entmagnetisiersequenz eine geringe differentielle Induktivität der Spule zur Verfügung. Das wiederum führt zu einem schnelleren Abfallen eines Sekundärgleichstromes bei nicht exakter Widerstandskompensation. In die Formel Is(t) geht die differentielle Induktivität als Ls ein. Eine kleinere Spuleninduktivität Ls führt zu einer kleineren Zeitkonstante T bei einem ohmschen Gesamtwiderstand Sekundärstromkreis Rg ungleich Null. Daher ist es wünschenswert, dass der Restmagnetfluss beim gewünschten Reststrom deutlich kleiner als der Sättigungsfluss ist also im Bereich eines steilen Anstieges der Magnetisierungskurve liegt.

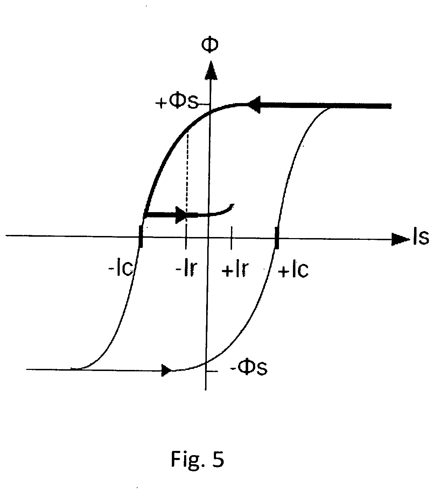

Bei einer Ausführungsform der Erfindung wird deshalb die Entmagnetisiersequenz um einen dritten Spannungsimpuls erweitert, der mit entgegengesetzter Spannungspolarität zum zweiten Spannungsimpuls an die Spule angelegt wird. In Fig. 5 ist die volle Magnetisierungskurve eines Stromwandlers skizziert. Dabei ist $\phi$ der mit der Spule verkettete Magnetfluss und Is der Sekundärstrom. Nach dem ersten Spannungsimpuls der Entmagnetisiersequenz ist der Kern gesättigt mit dem Sättigungsfluss $+\phi$s. Während des zweiten Spannungsimpulses folgt der Magnetfluss $\phi$ des Wandlerkerns dem Verlauf des hervorgehobenen Kurvenzuges. Bei einem Magnetfluss knapp unter $+\phi$s hat der Sekundärstrom bereits den Wert des Reststromes -Ir erreicht. Würde der Spannungsimpuls hier enden, wäre zwar der gewünschten Reststrom eingestellt aber der Kern würde in einem Bereich mit geringem Kurvenanstieg d$\phi$/dIs verbleiben und die differentielle Induktivität wäre gering. Dauert der Spannungsimpuls bis zum Erreichen von $\phi$=0 an, verbleibt zwar der Wandlerkern in einem Bereich mit großem Kurvenanstieg aber der Sekundärstrom hat fast den hohen Wert des Koerzitivstromes -Ic. Durch den dritten Spannungsimpuls, der kurz gegenüber dem ersten und dem zweiten Spannungsimpuls ist, wird der hohe Sekundärstrom abgebaut, wobei der Magnetfluss im Wandlerkern nur unwesentlich ansteigt. Der Kurvenverlauf zweigt von der vollen Magnetisierungskurve ab und endet beim Reststrom $+$Ir. Die Entmagnetisiersequenz mit drei Spannungsimpulsen ermöglicht somit eine optimale Einstellung von Reststrom und Restmagnetfluss.

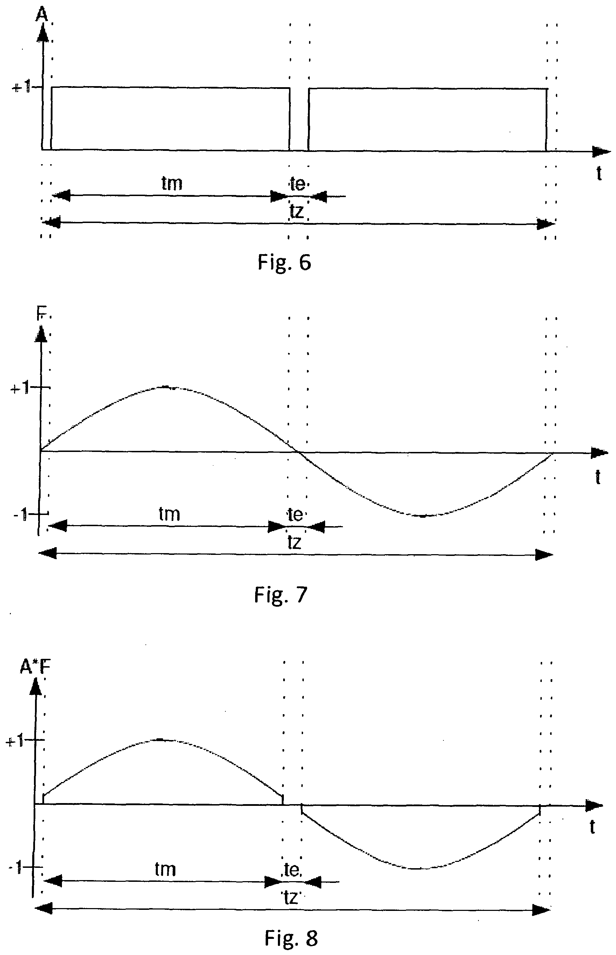

In einer anderen Ausführungsform wird während der Entmagnetisiersequenz, also während der Entmagnetisierzeit te, kein Gegenstrom und damit auch kein Differenzstrom ermittelt, so dass der zeitliche Verlauf des aus dem Sekundärstrom gewonnenen Messsignals somit gegenüber dem tatsächlichen Verlauf des Differenzstromes zyklische Lücken aufweist. Für die weitere Verarbeitung werden diese Lücken mit dem Momentanwert Null aufgefüllt. Mathematisch entspricht das einer Multiplikation des Differenzstromverlaufes mit einem rechteckförmigen Ausschnittsignal, wie es in Fig. 6 dargestellt ist.

Ferner wird das lückende Messsignal vor der weiteren Verarbeitung mit einem zyklusfrequenten und zyklussynchronen Sinussignal nach Fig. 7 multipliziert. Das Produkt aus dem obigen Ausschnittsignal und der sinusförmigen Fensterfunktion ist ein Sinussignal mit Lücken in den Nulldurchgängen nach Fig. 8.

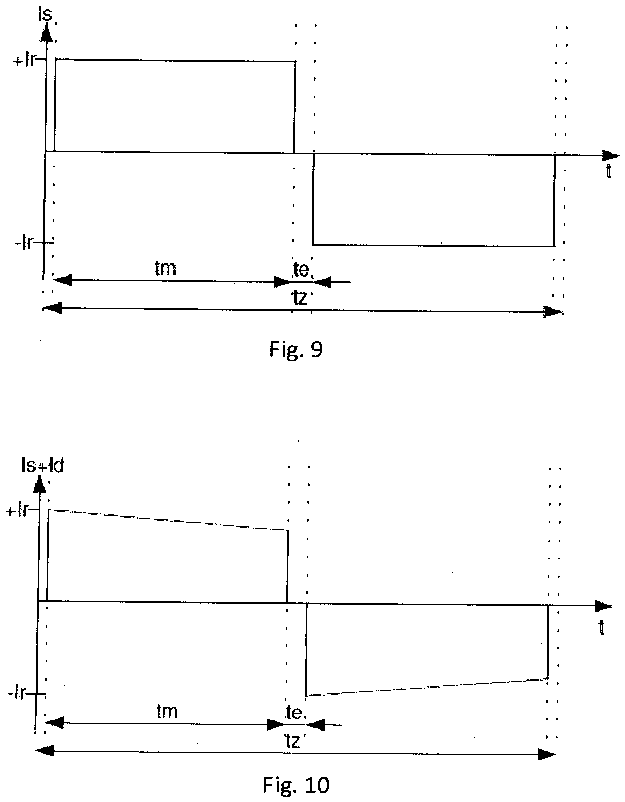

Fig. 9 zeigt den rechteckförmigen Magnetisierungswechselstrom, der durch die zyklischen Entmagnetisiersequenzen mit abwechselnder Polarität des Sättigungsflusses entsteht. Der Gegenstrom wird für die Darstellung als Null angenommen, sodass Sekundärstrom und Magnetsierungsstrom gleich sind. Der Verlauf des Sekundärstromes Is während der Entmagnetisiersequenzen ist nicht dargestellt. Die entstehenden Lücken sind mit dem Stromwert Null aufgefüllt. Es ist te die Entmagnetisierzeit, tm die Messzeit, tz die Zykluszeit und Ir der Reststrom.

In noch einer anderen Ausführungsform der Erfindung wird das Verfahren mit Hilfe von einem Mikroprozessor durchgeführt, der mittels Fourieranalyse die Signale in Harmonische zerlegt und bewertet.

Im weiteren Text wird auf die Harmonischen des rechteckförmigen Magnetisierungswechselstroms entsprechend Fig.9 Bezug genommen. Ein derartiges, rechteckförmiges Signal mit Lücken hat folgende Koeffizienten für die Cosinus- (Cn) und Sinusglieder (Sn) der Fourierreihe.

$$Cn = 0$$

$$Sn = 0 \quad \text{für n gerade} \quad Sn = \frac{4}{\pi n} \cdot \cos(n \cdot b) \quad \text{für n ungerade} \quad \text{mit} \quad b = \frac{te}{tz} \cdot \pi \quad (5)$$

Dabei ist n das Vielfache der Zyklusfrequenz, b die halbe Breite der Lücke im Bogenmaß. Diese und alle weiteren Fourierreihen im Text sind auf eine Signalamplitude von Eins und eine Periode von $2\pi$ normiert.

Im Messsignal sind jedoch außerdem unerwünschte Frequenzen vorhanden, die aus dem in Fig. 6 gezeigten rechteckförmigen Ausschnittsignal mit Lücken resultieren. Genauer gesagt sind die unerwünschten Frequenzen vorhanden, da der Stromverlauf der Entmagnetisierungssequenz durch Nullen ersetzt wurde, wobei die.Ersetzung mathematisch der Multiplikation des Sekundärstromverlaufes mit Rechteck entspricht und das Rechteck analytisch betrachtet aus vielen Frequenzen besteht.

Jeder Frequenzanteil des Ausschnittsignals multipliziert sich mit allen Frequenzanteilen des Differenzstromes, wobei jeweils Summen- und Differenzfrequenzen entstehen. Das Ausmaß in dem die unerwünschten Frequenzanteile entstehen hängt vom Frequenzspektrum des Ausschnittsignals ab. Seine Fourierreihe hat folgende Koeffizienten für die Cosinus- Cn und Sinusglieder Sn. Das Ausschnittsignal hat folgende Fourierkoeffizienten:

$$C_0 = 1 - \frac{2b}{\pi} \qquad Cn = -\frac{4}{\pi n} \cdot \sin(n \cdot b) \text{ für n gerade} \qquad Cn = 0 \text{ für n ungerade}$$

$$Sn = 0 \text{ mit} \qquad b = \frac{te}{tz} \cdot \pi \tag{6}$$

Dabei ist n das Vielfache der Zyklusfrequenz und b die halbe Breite der Lücke im Bogenmaß bezogen auf die Dauer eines Zyklus (Zykluszeit, tz).

Kleine Koeffizienten ergeben sich dann, wenn b klein ist. Je kleiner b ist, umso mehr ähnelt das Ausschnittsignal dem lückenlosen Einssignal, das bei Multiplikation keine Wirkung auf das Messsignal hat. Durch die in der Praxis begrenzte Entmagnetisierspannung kann die Entmagnetisierzeit te nicht beliebig klein werden. Ein kleines b setzt also eine hohe Zykluszeit voraus. Eine hohe Zykluszeit ist dann möglich, wenn die zeitliche Änderung des Magnetisierungsstromes während der Messintervalle auch bei hohem Differenzgleichstrom gering ist. Eine möglichst exakte Widerstandkompensation, die den Magnetfluss lange konstant hält, ist also Voraussetzung für einen geringen Anteil unerwünschter Frequenzen im Messsignal.

Die unerwünschten Frequenzanteile können durch die Verwendung der in Fig. 7 gezeigten Fensterfunktion noch weiter reduziert. So hat das in Fig. 8 gezeigte lückende Sinussignal hat folgende Fourierkoeffizienten.

$$Cn = 0$$

$$Sn = 0 \text{ für n gerade} \quad S_1 = 1 - \frac{2}{\pi} \cdot \left( b - \frac{1}{2} \cdot \sin(2b) \right) \tag{7}$$

$$Sn = -\frac{4}{\pi(1 - n^2)} \cdot (n \cdot \sin(b) \cdot \cos(n \cdot b) - \cos(b) \cdot \sin(n \cdot b)) \text{ für n ungerade}$$

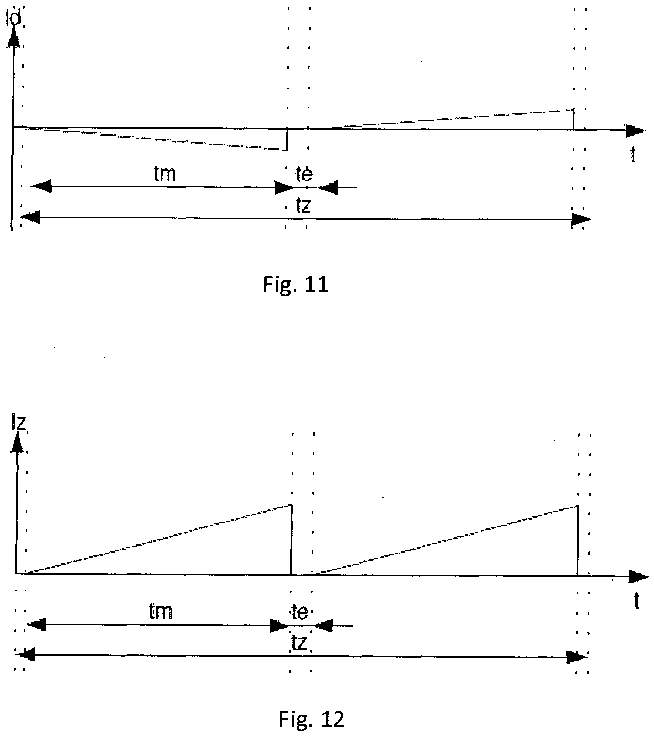

Um eine möglichst exakte Widerstandskompensation aufrecht zu erhalten, werden gemäß einer weiteren Ausführungsform der Erfindung Änderungen des temperaturabhängigen Spulenwiderstands kontinuierlich erkannt und ausgeglichen. Die Entmagnetisiersequenz ist deshalb erfindungsgemäß so gestaltet, dass ein ausreichend hoher Reststrom im Sekundärstromkreis verbleibt. Daraus resultiert der weiter oben erläuterte, in Fig. 9 dargestellte, ideale rechteckförmige Sekundärstromverlauf, wobei wiederum der Gegenstrom als null angenommen wird. Der Sekundärstromverlauf der Entmagnetisiersequenz ist nicht dargestellt. Der Sekundärstrom verursacht während des Messintervalls Spannungsabfälle über dem Spulenwiderstand der Spule und dem negativen Zweipolwiderstand. Bei Fehlkompensation ist die Summe der Spannungen ungleich null, was zu einer Magnetflussänderung und somit einer Änderung des Sekundärstromes führt. Bei Überkompensation, also einem zu großen Betrag des negativen Widerstands, steigt der Sekundärstrom an. Bei ein unvollständigen Kompensation bzw. Unterkompensation fällt er ab. Es entsteht der in Fig. 10 dargestellt Verlauf, der als Summe aus dem ursprünglichen, rechteckförmigen Sekundärstrom aus Fig. 9 und dem in Fig. 11 dargestellten, doppelsägezahnförmigen Signal betrachtet wird.

Das Vorhandensein und die Polarität eines entsprechenden doppelsägezahnförmigen Anteils können wiederum durch eine Korrelation ermittelt werden. Dabei wird die Tatsache ausgenutzt, dass die Fourierreihe eines derartigen doppelsägeförmigen Signals Cosinusanteile hat, die in einem Rechtecksignal nach Fig. 9 nicht enthalten sind. Ein doppelsägezahnförmiges Signal in der Form von Fig. 11 hat folgende Fourierkoeffizienten:

$$Cn = 0 \text{ für n gerade}$$

$$Cn = -\frac{2}{\pi n} \cdot \sin(n \cdot b) + \frac{4}{\pi(\pi - 2b) \cdot n^2} \cdot \cos(n \cdot b) \text{ für n ungerade} \tag{8}$$

$$Sn = 0 \text{ für n gerade} \qquad Sn = -\frac{2}{\pi n} \cdot \cos(n \cdot b) \text{ für n ungerade}$$

Je nach ermittelter Polarität der C1-Komponente wird der negative Widerstand erhöht oder verringert und damit die Widerstandkompensation geregelt.

Bevorzugt wird bei der Ermittlung der C1-Komponente die oben beschriebene Fensterfunktion verwendet. Wegen

$$\sin(x)\cdot\cos(y)=\frac{1}{2}\cdot(\sin(x+y)+\sin(x-y)) \qquad (9)$$

wird bei der Multiplikation des Messsignals mit der Fensterfunktion aus der C1-Komponente ein Sinussignal S2 mit doppelter Zyklusfrequenz. Entsprechend wird dann korreliert.

Von einem sägezahnförmigen Signal, also einem Signal mit linearem Anstieg zu sprechen ist eine zulässige Vereinfachung, da die Amplitude des doppelsägezahnförmigen Signals gegenüber dem Reststrom sehr klein ist. Nach Gleichung (1) für Is(t) entspricht das einem gegenüber der Zeitkonstante T sehr kleinen t, sodass der Verlauf von Is(0) bis Is(t) als Gerade genähert werden kann.

Ein Ziel der Widerstandskompensation ist es, die Induktionsspannung Ui über der Spuleninduktivität Ls in Fig. 1 unabhängig vom Sekundärstrom auf dem Wert Null zu halten. Bei der Verwendung von Operationsverstärkern kann durch deren Offsetspannung dem Messsignal eine Gleichspannung überlagert werden. In Anlehnung an die Operationsverstärkertechnik wird hier mit Offsetspannung (Uo) die Summe aller unerwünschten Gleichspannungen im Sekundärstromkreis bezeichnet. Tritt nun im Sekundärstromkreis eine Offsetspannung auf, wird nach dem Maschensatz die Induktionsspannung ungleich Null und entspricht der Offsetspannung. Das hat eine zeitliche Änderung des Magnetflusses und des Magnetisierungsstromes zur Folge und führt zu Messfehlern beim Differenzstrom. Der Magnetisierungsstrom ändert sich dabei linear mit der Geschwindigkeit dI/dt = Ui/Ls.

Eine ausreichend kleine Offsetspannung Uo bieten speziell abgeglichene Präzisionsoperationsverstärker oder Chopper-Verstärker. Wegen ihrer geringen Bandbreite sind Chopper-Verstärker hier nicht einsetzbar. Präzisionsoperationsverstärker erhöhen die Kosten für die Elektronik, was nicht im Sinne der gestellten Aufgabe ist.

Gemäß einer besonderen Ausführungsform der Erfindung wird daher eine weitere steuerbare Spannungsquelle Offsetkompensation 24 in den Sekundärstromkreis eingebracht. Diese Offsetspannungsquelle 24 wird dabei derart gesteuert, dass ihre Spannung der Offsetspannung entgegengerichtet ist und diese kompensiert, sodass und die Induktionsspannung wieder gleich Null wird. Um diese Offsetkompensation möglichst exakt aufrecht zu erhalten, müssen Änderungen der temperaturabhängigen Offsetspannung kontinuierlich erkannt und ausgeglichen werden. Bei exakter Offsetkompensation entsteht der in Fig. 9 dargestellte rechteckförmige Sekundärstromverlauf, wobei für die Darstellung wiederum der Gegenstrom als null angenommen wird. Bei Fehlkompensation überlagert sich diesem rechteckförmigen Signalverlauf ein sägezahnförmiges Signal nach Fig. 12. Das Vorhandensein und die Polarität eines entsprechenden sägezahnförmigen Signals im Messsignal kann durch Korrelation ermittelt werden, weil das sägezahnförmige Signal mit S2 eine Harmonische der Zyklusfrequenz enthält, die weder im rechteckförmigen Magnetisierungswechselstrom noch im doppelsägezahnförmigen Signal der Widerstandskompensation vorkommt. Das sägezahnförmige Signal nach Fig. 12 hat folgende Fourierkoeffizienten:

$$C_0=\frac{1}{2}-\frac{2b}{\pi} \quad Cn=-\frac{2}{\pi n}\cdot\sin(n\cdot b) \text{ für n gerade } \quad Cn=0 \text{ für n ungerade}$$

$$Sn=-\frac{2}{\pi n}\cdot\cos(n\cdot b)-\frac{4}{\pi(\pi-2b)n^2} \text{ für n gerade } \quad Sn=0 \text{ für n ungerade}$$

$$(10)$$

In Abhängigkeit von der Polarität der ermittelten S2-Komponente im Messsignal wird die Spannung der steuerbaren Spannungsquelle 24 erhöht oder verringert und damit die Offsetkompensation geregelt.

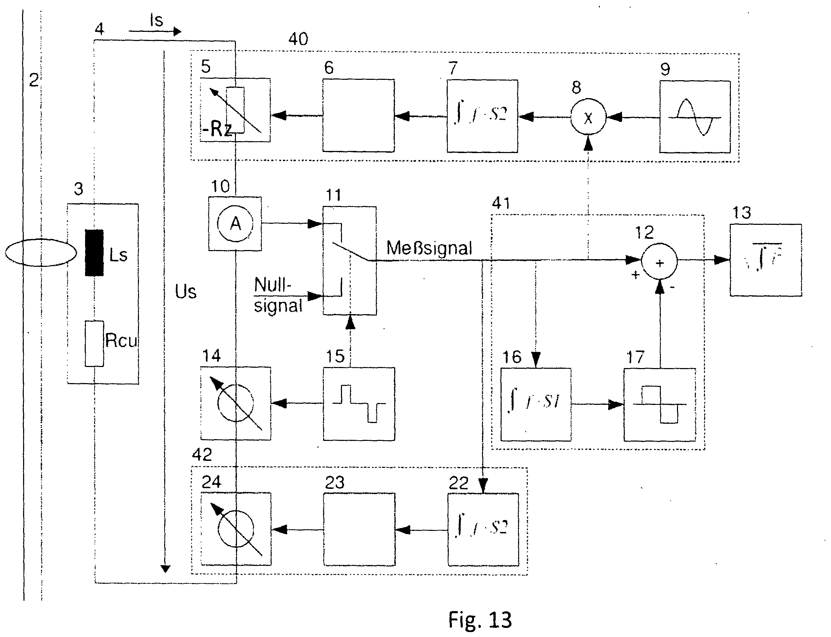

Anhand von Fig. 13 wird im Folgenden ein Beispiel für eine erfindungsgemäße Vorrichtung und der Signalfluss näher erläutert. Fig. 13 zeigt das Blockschaltbild einer Vorrichtung zur Durchführung des Verfahrens. Bei der hier gezeigten Ausführungsform weist der Sekundärstromkreis 4 eines Reihenschaltung von Spule 3, den negativen Zweipolwiderstand Rz bildenden Zweipol 5, Stromerfassung 10 für den Sekundärstrom Is, eine steuerbarer Spannungsquelle Entmagnetisiersequenz 14 und eine steuerbarer Spannungsquelle 24 zur Offsetkompensation auf.

Stromerfassung 10 und Umschalter 11 erzeugen aus dem Sekundärstrom Is das Messsignal. Die Steuerung 15 für die Entmagnetisiersequenz steuert die Stellung von Umschalter 11 derart, dass das Messsignal während der Entmagnetisierzeit te dem Nullsignal und während der Messzeit tm dem Ausgangssignal der Stromerfassung 10 entspricht.

Steuerung 15 erzeugt die Entmagnetisiersequenzen und steuert über den Eingang der Spannungsquelle 14 die in den Sekundärstromkreis 4 eingebrachte Spannung.

Das Messsignal von Umschalter 11 wird über den Summierer 12 der Effektivwertbildung 13 zugeführt. Summierer 12, Korrelator 16 der Reststromkompensation 41 und Rechteckgenerator 17 der Reststromkompensation 41 entfernen dabei aus dem Messsignal den Anteil des rechteckförmigen Magnetisierungswechselstromes. Dazu wird das Messsignal auch dem Korrelator der Reststromkompensation 16 zugeführt, der über die Amplitude der Grundwelle S1 des rechteckförmigen Magnetsierungswechselstromes die Amplitude des rechteckförmigen Magnetisierungswechselstromes ermittelt. Die ermittelte Amplitude wird dem Rechteckgenerator 17 zugeführt. Dieser erzeugt ein zyklusfrequentes, zyklussynchrones Rechtecksignal mit der von Korrelator 16 Reststromkompensation 41 vorgegebenen Amplitude. Der Signalverlauf am Ausgang von Rechteckgenerator 17 entspricht somit dem Verlauf des Magnetisierungsstromes im Messsignal. Der Summierer 12 subtrahiert vom Messsignal das vom Rechteckgenerator 17 auf diese Weise erzeugte Korrektursignal und führt das Ergebnis der Effektivwertbildung 13 zu.

Fensterfunktion-Generator 9, Multiplizierer 8, Sägezahnsignal-Korrelator 7, Regler 6 der Widerstandskompensation 40 und Zweipol 5 der Widerstandkompensation 40 dienen der Kompensation des Spulenwiderstandes Rcu der Spule und der Regelung der Widerstandskompensation. Dazu wird den Eingängen von Multiplizierer Widerstandskombination 8 auch das Messsignal und das zyklusfrequente und zyklussynchrone Sinussignal vom Generator Widerstandskompensation 9 zugeführt und damit die Fensterfunktion über das Messsignal gelegt. Das Produkt der beiden Signale wird dem Korrelator Sägezahnsignal 7 zugeführt. Korrelator Sägezahnsignal 7 ermittelt über die Amplitude der Harmonisches S2, die im Multiplizierer 8 aus der Harmonischen C1 im Messsignal entsteht, die Amplitude und Polarität des doppelsägezahnförmigen Signals im Messsignal. Regler Widerstandskompensation 6 steuert den negativen Widerstand von Zweipol 5 derart, dass die von Korrelator Sägezahnsignal 7 ermittelte Amplitude gleich Null wird, also der negative Widerstand von Zweipol 5 den ohmschen Widerstand Rcu der Sekundärspule kompensiert. Korrelator 22, Regler 23 und steuerbare Spannungsquelle 24 der Offsetkompensation 42 dienen der Kompensation der Offsetspannung im Sekundärstromkreis 4 und der Regelung dieser Kompensation. Korrelator 22 ermittelt über die Amplitude Harmonischen S2 im Messsignal die Amplitude des sägezahnförmigen Anteils im Messsignal. Regler 23 steuert die steuerbare Spannungsquelle 24 derart, dass die Amplitude gleich Null wird, also die Offsetspannung des Sekundärstromkreises von der Spannung der steuerbaren Spannungsquelle 24 kompensiert wird.

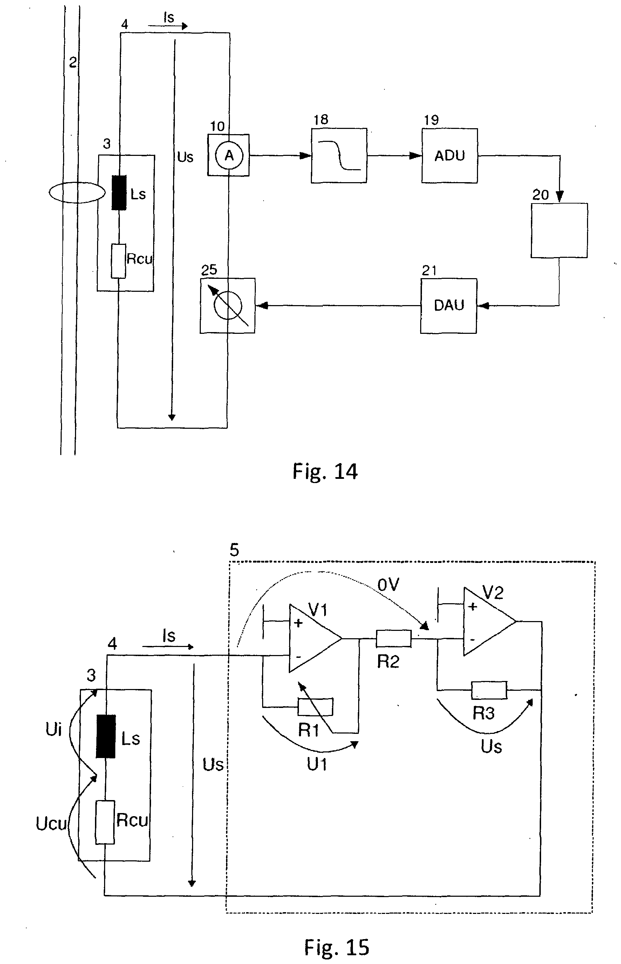

In Fig. 14 wird eine andere sehr vorteilhafte Ausführungsform der Erfindung gezeigt. Das mit Stromerfassung 10 gewonnene Signal wird über Aliasing-Filter 18 und Analog-Digital-Umsetzer 19 dem Rechner 20 zugeführt. Rechner 20 steuert über Digital-Analog-Umsetzer 21 und Spannungsquelle 25 die in den Sekundärstromkreis 4 eingebrachte Spannung.

Während der Messintervalle steuert der Rechner 20 die Spannungsquelle 25 derart, dass die Reihenschaltung aus Stromerfassung 10 und Spannungsquelle 25 den Zweipol mit negativem, ohmschem Widerstand -Rcu bildet. Der Rechner 20 erzeugt auch die Entmagnetisiersequenzen und bringt über Spannungsquelle 25 die nötigen Spannungen in den Sekundärstromkreis 4 ein. Außerdem ermittelt er den Reststrom und regelt die Widerstandskompensation. und die Offsetkompensation.

Diese Ausführungsform kann vorteilhaft dazu verwendet werden, die für das Verfahren notwendigen Parameter des jeweils verwendeten Stromwandlers zu ermitteln. Ein Anfangswert für den ohmschen Widerstand wird ermittelt, indem über die Spannungsquelle 25 eine Gleichspannung in den Sekundärstromkreis 4 eingebracht und über die Stromerfassung 10 der sich einstellende Gleichstrom gemessen wird. Temperaturabhängige Änderungen des ohmschen Widerstandes der Sekundärspule werden später, wie im Verfahren beschrieben, erkannt und die Widerstandskompensation geregelt.

Ferner wird der Sättigungsfluss ermittelt, indem der Rechner 20 über Spannungsquelle 25 eine rechteckförmige Wechselspannung in den Sekundärstromkreis 4 einbringt. Dabei wechselt der Rechner 20 immer dann die Spannungspolarität, wenn er mit Hilfe von Stromerfassung 10 den für die Sättigung typischen, sprunghaften Anstieg des Sekundärstromes erkennt. Dadurch pendelt der Kern zwischen seinen beiden Sättigungsflüssen hin und her. Aus der Periodendauer der sich ergebenden Schwingung und der Amplitude der Wechselspannung wird dann der Sättigungsfluss berechnet.

Vorteilhaft an dieser Ausführungsform ist weiter, dass die für das Messverfahren nötige Signalverarbeitung nach Fig. 13 weitgehende durch Software realisiert wird. Der Aufwand an Elektronik ist gering, was zu niedrigen Kosten führt und daher sehr im Sinne der gestellten Aufgabe ist. Der geringe Platzbedarf der Elektronik erleichtert die Konstruktion mehrkanaliger Vorrichtungen zur Durchführung des Verfahrens, an die gleich mehrere Stromwandler angeschlossen werden können. Mehrere Kanäle teilen sich somit Rechner, Stromversorgung und Kommunikationselektronik einer solchen Vorrichtung. Die für die Errichter elektrischer Anlagen maßgeblichen Kosten pro Überwachungskanal, verringern sich dadurch weiter.

Im Folgenden wird unter Bezugnahme auf Fig. 15 beispielhaft eine mögliche Einrichtung zur Widerstandskompensation mit einem aktiven Zweipol mehr im Detail erläutert. Bei der hier gezeigten Ausführungsform weist der Sekundärstromkreis 4 eine Reihenschaltung von Sekundärspule 3, den negativen Zweipolwiderstand Rz bildenden Zweipol 5 mit Verstärker V1 und V2 auf. Verstärker V1 arbeitet als Strom-Spannungs-Umsetzer mit dem Übertragungsfaktor F1 = U1/Is = R1. V2 ist als invertierender Verstärker mit F2 = Us/U1 = -R3/R2 beschaltet. Für R2=R3 ergibt sich als Übertragungsfaktor für den Zweipol F1*F2 = -R1. Wird also die dargestellte Schaltung von einem positiven Sekundärstrom Is durchflossen, stellt sich ein negativer Spannungsabfall Us = -R1*Is ein. Die Schaltung bildet einen negativen, ohmschen Widerstand.

Für exakte Widerstandskompensation wird der Widerstand R1 auf den Wert Rcu eingestellt. Bei beliebigem Sekundärstrom Is ergibt sich dann für den Spannungsabfall Ui über der Spuleninduktivität -Ui = Ucu+Us = 0. Bei exakter Widerstandskompensation lässt der Sekundärstromkreis 4 keine Induktionsspannung Ui also keine zeitliche Magnetflussänderung im Kern zu. Die kleinste Induktionsspannung würde am ohmschen Gesamtwiderstand des Sekundärstromkreises, der gleich Null ist, sofort zu einem hohen Sekundärstrom führen, der der Magnetflussänderung entgegenwirkt.

In noch einer anderen Ausführungsform werden ferner lange Korrelationszeiten verwendet, so dass insgesamt nur eine träge Reaktion auf Korrelationsergebnisse erfolgt. Bevorzugt wird durch Korrelation über viele Messzyklen hinweg und durch eine niedrige Zyklusfrequenz um 0,3 Hz eine kleine Bandbreite der Amplitudenmessung erreicht. Der Frequenzbereich, in dem ein Frequenzanteil des Differenzstromes zu Messfehlern führen kann, wird schmal. Es ist auch vorgesehen, dass plötzliche Änderungen im Korrelationsergebnis als Störung gewertet werden, auf welche hin die Korrelationsergebnisse verworfen werden und ggf. die Zyklusfrequenz und damit der sensible Frequenzbereich gewechselt wird.

Dadurch wird vorteilhaft erreicht, dass das Messverfahren weniger durch ungünstige Frequenzanteile im Differenzstrom gestört werden kann. Dies ist insbesondere von Bedeutung bei der Ermittlung des Reststromes und bei der Regelung der Widerstandskompensation und bei der Regelung der Offsetkompensation, wo die Amplituden bestimmter, zyklussynchroner Frequenzanteile im Messsignal durch Korrelation (S1, C1, S2) gemessen werden. Enthält der Differenzstrom selbst diese Frequenzen, können dabei nämlich prinzipiell Messfehler auftreten.

Es wird deswegen erfindungsgemäß die Tatsache genutzt, dass Änderungen des Reststromes und des ohmschen Widerstandes der Sekundärspule durch Temperaturänderungen entstehen also langsame Vorgänge sind. Daher deuten schnelle Änderungen der Korrelationsergebnisse deuten auf einen störenden Frequenzanteil im Differenzstrom hin.

Ein Vorteil ist daher auch, dass in die vom Kern umfassten Leiter keine Störspannung induziert wird. Der im Stand der Technik beschriebene Multivibrator legt an die Sekundärspule eine rechteckförmige, steilflankige Wechselspannung an. Obwohl die Multivibratorfrequenz gewöhnlich unter 1kHz liegt, reichen die Harmonischen bis über 150kHz hinauf und sind damit für die Beurteilung der elektromagnetischen Verträglichkeit der Einrichtung relevant.

Formelzeichen

| | |
|---|---|
| A | Ausschnittsignal |
| B | magnetische Flussdichte |
| Bs | Sättigungsflussdichte |
| Cn | Fourier Cosinuskoeffizienten |
| F | Fensterfunktion |
| F1 | Übertragungsfaktor |
| F2 | Übertragungsfaktor |
| $\phi$ | verketteter Magnetfluss |
| $\phi$s | Sättigungsfluss |
| H | magnetische Feldstärke |
| Ib | Maximalwert des Sekundärstromes |
| Ic | Koerzitivstrom |
| Id | doppelsägezahnförmiges Signal |
| Ir | Reststrom |
| Is | Sekundärstrom |
| Is0 | Anfangswert des Sekundärgleichstromes |
| Iz | sägezahnförmiges Signal |
| Ls | Spuleninduktivität |
| R1 | Widerstand |
| R2 | Widerstand |
| R3 | Widerstand |
| Rcu | ohmscher Widerstand |
| Rg | ohmscher Gesamtwiderstand Sekundärstromkreis |
| Rz | Zweipolwiderstand |
| Sn | Fourier Sinuskoeffizienten |
| T | Zeitkonstante |
| U1 | Verstärkerausgangsspannung |

Ucu    Spannung über dem ohmschen Widerstand
Ue     Entmagnetisierspannung
Ui      Induktionsspannung
Us     Spulenspannung
b       halbe Breite der Lücke im Bogenmaß
fz      Zyklusfrequenz
n       Vielfaches der Zyklusfrequenz
t        Zeit
t1      Dauer des ersten Spannungsimpulses
t2      Dauer des zweiten Spannungsimpulses
te      Entmagnetisierzeit
tm     Messzeit
tz      Zykluszeit
Uo     Offsetspannung
A       rechteckförmiges Ausschnittsignal
Wie    rechteckförmiger Magnetisierungswechselstrom

Bezugszeichen

1      Spannungs-Zeit-Fläche
2      Primärleiter
3      Sekundärspule
4      Sekundärstromkreis
5      Zweipol
6      Regler Widerstandskompensation
7      Korrelator Sägezahnsignal
8      Multiplizierer Widerstandskompensation
9      Generator Fensterfunktion
10    Stromerfassung
11    Umschalter
12    Summierer der Reststromkompensation
13    Effektivwertbildung
14    Spannungsquelle Entmagnetisiersequenz
15    Steuerung Entmagnetisiersequenz
16    Korrelator Reststromkompensation
17    Rechteckgenerator
18    Aliasing-Filter
19    Analog-Digital-Umsetzer
20    Rechner
21    Digital-Analog-Umsetzer
22    Korrelator Offsetkompensation
23    Regler Offsetkompensation
24    Spannungsquelle Offsetkompensation
25    Spannungsquelle
V1    Operationsverstärker
V2    Operationsverstärker
R1    Widerstand
R2    Widerstand
R3    Widerstand
40    Widerstandskompensation
41    Reststromkompensation
42    Offsetkompensation
43    Wandlerkern
44    Spannungsimpuls

**Patentansprüche**

1.  Verfahren zur Messung elektrischer Ströme mit Hilfe eines Stromwandlers, **gekennzeichnet dadurch, dass**

    • im Sekundärstromkreis (4) des Stromwandlers der ohmsche Widerstand (Rcu) der Sekundärspule (3) mit Hilfe eines einen negativen ohmschen Widerstand (Rz) bildenden aktiven Zweipols (5) kompensiert wird, zur Aufrechterhaltung des Gleichstromanteils eines von einem Primärstrom induzierten Sekundärstroms (Is) in der Sekundärspule,
    wobei der Betrag des negativen Widerstandes des Zweipols (5) dem ohmschen Widerstand (Rcu) der Sekundärspule (3) entspricht und wobei der Sekundärstrom (Is) des Stromwandlers gemessen wird, zur Ermittlung des dem Mischstrom der Primärleiter entsprechenden Sekundärgleichstroms und/oder Gegenstroms,
    • zur Herstellung eines definierten magnetischen Flusses im Wandlerkern eine vorbestimmte Impulsfolge über eine Magnetspule auf den Wandlerkern gegeben wird, wobei

    der Wandlerkern durch Anlegen eines ersten Spannungsimpulses oder eines Stromes an eine Spule des Wandlers bis zum Sättigungsfluss ($\phi$s) magnetisiert wird, und
    anschließend durch Anlegen eines zweiten Spannungsimpulses umgekehrter Polarität und definierter Spannungs-Zeit-Fläche der (1) magnetische Fluss wieder reduziert wird.

2.  Verfahren nach Anspruch 1, bei dem die Spannungs-Zeit-Fläche (1) des zweiten Spannungsimpulses derart gewählt und auf dem zweiten Spannungsimpuls folgend ein definierter dritter Spannungsimpuls mit zu dem zweiten Spannungsimpuls umgekehrter Polarität angelegt wird, dass im Wandler ein Arbeitspunkt erreicht wird, bei dem mit einem im Verhältnis zum Sättigungsstrom kleinem Magnetisierungsstrom die differentielle Induktivität des Wandlers möglichst groß ist.

3.  Verfahren nach Anspruche 1 oder 2, bei dem der dem hergestellten definierten magnetischen Fluss entsprechende Magnetisierungsstrom in der Sekundärspule (3) bestimmt wird, indem ein Magnetisierungswechselstrom erzeugt wird, indem die Impulsfolge mit einer vorbestimmten Frequenz abwechselnd, mit jeweils umgekehrten Vorzeichen, für beide Sättigungspolaritäten angelegt wird.

4.  Verfahren nach Anspruch 3, bei dem Messzyklen mit einer Zykluszeit (tz) gebildet werden, die in jeder Periode ein Zeitintervall mit Entmagnetisierungszeit (te) und ein Zeitintervall mit Messzeit (tm) aufweist.

5.  Verfahren nach Anspruch 3 oder 4, bei dem die Amplitude des entstehenden Magnetisierungswechselstromes ermittelt und ein Korrektursignal erzeugt wird, das in Verlauf und Amplitude einem rechteckförmigen Magnetisierungswechselstrom entspricht, und das Messsignal entsprechend um das ermittelte Korrektursignal korrigiert wird.

6.  Verfahren nach einem der vorhergehenden Ansprüche, wobei das Messsignal für eine weitere Verarbeitung bereinigt wird derart, dass alle Zeitintervalle (te) in dem Messsignal, die einem Zeitintervall eines Spannungsimpulse der vorbestimmten Impulsfolge einer Polarität entsprechen, mit einem vorbestimmten konstanten Wert, insbesondere mit dem Wert Null, versehen werden.

7.  Verfahren nach Anspruch 6, wobei das bereinigte Messsignal ferner mit einer Fensterfunktion, insbesondere einem zyklusfrequenten und zyklussynchronen Sinussignal, multipliziert wird.

8.  Verfahren nach einem der vorhergehenden Ansprüche, bei dem die Größe des erzeugten negativen ohmschen Widerstands (Rz) anhand einer ermittelten unvollständigen Kompensation bzw. Überkompensation des ohmschen Widerstands (Rcu) der Sekundärspule (3) geregelt wird.

9.  Verfahren nach Anspruch 8, bei dem die unvollständige Kompensation oder Überkompensation des ohmschen Widerstands (Rcu) der Sekundärspule (3) ermittelt wird, indem aus dem Messsignal die Amplitude einer Harmonischen ermittelt wird, die bei Abweichung eines Magnetisierungswechselstromes von einer rechteckförmigen Signalform auftritt.

10. Verfahren nach einem der vorhergehenden Ansprüche, bei dem eine im Sekundärkreis auftretende insbesondere durch verwendete elektronische Bauteile verursachte Offsetspannung ermittelt wird und anschliessend kompensiert wird.

**11.** Verfahren nach Anspruch 10, bei dem der Wert der Offsetspannung mittels Korrelation ermittelt wird, indem aus dem Messsignal die Amplitude einer Harmonischen ermittelt wird, mit der ein einfaches sägezahnförmiges Signal (Iz) gegenüber einem doppelsägezahnförmigen Signal Id oder rechteckförmigen Signal unterschieden wird.

**12.** Verfahren nach einem der vorhergehenden Ansprüche, angewandt zur Messung von Differenzströmen oder Fehlerströmen in einer elektrischen Vorrichtung, die neben einem Wechsel- auch einen Gleichstromanteil enthalten.

**13.** Verfahren nach einem der vorhergehenden Ansprüche, wobei die Magnetspule zum Geben der vorbestimmten Impulsfolge in den Wandlerkern die Sekundärspule (3) des Wandlers ist.

**14.** Vorrichtung zur Messung elektrischer Ströme, die mindestens einen Stromwandler aufweist, zum Koppeln mit den sekundären Klemmen des Stromwandlers und, in Verbindung mit dem Stromwandler, eingerichtet zur Durchführung des Messverfahrens nach einem der Ansprüche 1 bis 13.

**15.** Vorrichtung gemäss Anspruch 14, wobei die Vorrichtung mindestens eine steuerbare Spannungsquelle (25) und mindestens eine Stromerfassung (10), die mit einer Steuerung verbunden sind, aufweist.

**16.** Vorrichtung nach Anspruch 15, aufweisend einen aktiven Zweipol (5), der über einen ersten Regler mit der Stromerfassung (10) verbunden ist, so dass ein Regelkreis für definierte Frequenzanteile eines über die Stromerfassung (10) erzeugten Messsignals gebidet wird.

**17.** Vorrichtung gemäss Anspruch 15 oder 16, ferner aufweisend einen zweiten Regler (6) zum Anpassen des negativen Zweipolwiderstandes (Rz) an den temperaturabhängigen ohmschen Spulenwiderstand.

**18.** Vorrichtung gemäss Anspruch 17, bei dem der zweite Regler ausgebildet ist, die das Anpassen des negativen Zweipolwiderstandes (Rz) über Fourierkoeffizienten und mittels der Kompensation unerwünschter Frequenzanteile des Messsignals durchzuführen.

**19.** Vorrichtung gemäss einem der Ansprüche 15 bis 18, wobei die Steuerung mit einem Mikrocontroller implementiert ist.

**20.** System zur Messung elektrischer Ströme, aufweisend einen induktiven Stromwandler und die Vorrichtung gemäss einem der Ansprüche 15 bis 19.

**21.** Verfahren zur Messung von elektrischen Strömen mit Hilfe eines Stromwandlers, aufweisend die Schritte:

• Erweitern der Schaltung des Sekundärkreises (4) des Stromwandlers mit einer elektrischen Vorrichtung, so dass ein einen negativen ohmschen Widerstand (Rz) bildender aktiver Zweipol (5) und eine Stromerfassung (10) im Sekundärkreis (4) des Wandlers in Reihe geschaltet sind, und eine Spannungsquelle (25) im Stromkreis einer Sekundärspule (3) des Wandlers in Reihe geschaltet ist, und eine Steuereinheit mit der Stromerfassung (10) und mit der Spannungsquelle (25) verbunden ist;
• Auslesen der Stromerfassung (10) sowie Ansteuern der Spannungsquelle (25) mittels der Steuereinheit, zur Ausführung des Verfahrens gemäss einem der Ansprüche 1 bis 13; und
• Ausgeben eines Ausgangssignals von der Steuereinheit, das den Gleichstromanteil sowie den Wechselstromanteil eines elektrischen Primärstromes des Wandlers enthält.

**Claims**

**1.** Method for measuring electrical currents by means of a current transformer due to the facts that

• the ohmic resistance (Rcu) of the secondary coil (3) in the secondary circuit (4) is compensated by an active dipole (5) producing a negative ohmic resistance (Rz), for maintaining the DC component of a secondary current (Is) induced by a primary current in the secondary coil,
whereby the absolute value of the negative resistance of the dipole (5) corresponds to the ohmic resistance (Rcu) of the secondary coil (3) and whereby the secondary current (Is) of the current transformer is measured for determination of the secondary DC current and/or countercurrent corresponding to the mixed current of the primary conductor,
• for generating of a defined magnetic flux in the transformer core, a predefined pulse sequence is applied to the transformer core via a magnetic coil whereby the transformer core is magnetised by applying a first voltage pulse or a current to a coil of the transformer up to the saturation flux (Os), and subsequently, the magnetic flux is reduced again by applying a second voltage pulse of inverse polarity and defined voltage-time integral (1).

2. Method according to claim 1 wherein the voltage-time integral (1) of the second voltage pulse is selected in such way and a defined third voltage pulse with inverse polarity compared to the second voltage pulse is applied following the second voltage pulse that an operating point is reached in the transformer where the residual inductance of the transformer is as high as possible at a low magnetising current compared to the saturation current.

3. Method according to claim 1 or 2 wherein the magnetising current in the secondary coil (3) corresponding to the generated defined magnetic flux is determined by applying the pulse sequence with a predefined frequency alternating with respectively inverse signs for both saturation polarities.

4. Method according to claim 3 wherein measurement cycles with a cycle time (tz) are created which have a time interval with demagnetising time (te) and a time interval with measurement time in each period.

5. Method according to claim 3 or 4 wherein the amplitude of the generated magnetising AC current is determined and a correction signal is generated which corresponds to a rectangular magnetising AC current concerning course and amplitude and the measurement signal is respectively corrected by the determined correction signal.

6. Method according to one of the above mentioned claims wherein the measurement signal is cleaned for further processing in such way that all time intervals (te) in the measurement signal corresponding to a time interval of a voltage pulse of the predefined pulse sequence of a polarity are provided with a predefined constant value, especially 0.

7. Method according to claim 6 wherein the cleaned measurement signal is also multiplied by a window function, especially a cycle frequent and cycle synchronous sinusoidal signal.

8. Method according to one of the above mentioned claims wherein the dimension of the generated negative ohmic resistance (Rz) is controlled by means of a determined incomplete compensation resp. overcompensation of the ohmic resistance (Rcu) of the secondary coil (3).

9. Method according to claim 8 wherein the incomplete compensation or overcompensation of the ohmic resistance (Rcu) of the secondary coil (3) is determined by determining the amplitude of a harmonic from the measurement signal which occurs in case of a deviation of a magnetising AC current from a rectangular signal shape.

10. Method according to one of the above mentioned claims wherein an offset voltage caused by the electrical components used occuring in the secondary circuit is determined and compensated in the following.

11. Method according to claim 10 wherein the value of the offset voltage is determined by correlation by determining the amplitude of a harmonic from the measurement signal to distinguish a single sawtooth signal (Iz) from a double sawtooth signal Id or from a rectangular signal.

12. Method according to one of the above mentioned claims used for measurement of residual currents or fault currents in an electrical device having not only an AC component but also a DC component.

13. Method according to one of the above mentioned claims wherein the magnetic coil for feeding the pre-defined pulse sequence into the transformer core is the secondary coil (3) of the transformer.

14. Device for measuring electric currents which has at least one current transformer for coupling with the secondary terminals of the current transformer and, in connection with the current transformer, is designed for carrying out the measurement according to one of the claims 1 to 13.

15. Device according to claim 14 wherein the device has at least one controllable voltage supply (25) and at least one current measurement (10) which is connected to a control.

16. Device according to claim 15 having an active dipole (5) which is connected to the current measurement (10) via a first controller so that a control circuit for defined frequency components of a measurement signal generated by the current measurement is created.

**17.** Device according to claim 15 or 16 additionally having a second controller (6) for adapting the negative dipole resistance (Rz) to the temperature dependent ohmic coil resistance.

**18.** Device according to claim 17 wherein the second controller is designed for adapting the negative dipole resistance (Rz) by Fourier coefficients and by means of the compensation of undesired frequency components of the measurement signal.

**19.** Device according to claims 15 to 18 wherein the control is implemented with a microcontroller.

**20.** System for measuring electric currents having an inductive current transformer and the device according to one of the claims 15 to 19.

**21.** Method for measuring electric currents by means of a current transformer by the following steps:

• Extension of the circuit of the secondary circuit (4) of the current transformer by an electrical device so that an active dipole (5) generating a negative ohmic resistance (Rz) and a current measurement (10) in the secondary circuit (4) of the current transformer is in series; and a voltage supply (25) in the circuit of a secondary coil (3) of the transformer is in series; and a control unit is connected to the current measurement (10) and to the voltage supply (25);
• reading the current measurement (10) as well as controlling the voltage supply via control unit for conducting the method according to one of the claims 1 to 13; and
• outputting an output signal by the control unit having a DC component as well as an AC component of an electrical primary conductor of the transformer.

**Revendications**

**1.** Procédé de mesure de courants électriques à l'aide d'un transformateur de courant, **caractérisé en ce que**

• la résistance ohmique (Rcu) de la bobine secondaire (3) est compensée dans le circuit secondaire (4) du transformateur de courant à l'aide d'un dipôle (5) actif formant une résistance ohmique négative (Rz), afin de maintenir la partie formant courant continu d'un courant secondaire (Is) induit par un courant primaire dans la bobine secondaire,
dans lequel la valeur de la résistance négative du dipôle (5) correspond à la résistance ohmique (Rcu) de la bobine secondaire (3), et
dans lequel le courant secondaire (Is) du transformateur de courant est mesuré pour déterminer le courant continu secondaire et/ou le courant inverse correspondant au courant mixte des conducteurs primaires,
• une séquence d'impulsions prédéterminée est délivrée par l'intermédiaire d'une bobine magnétique au noyau du transformateur pour produire un flux magnétique défini, dans lequel
le noyau du transformateur est magnétisé par application d'une première impulsion de tension ou d'un courant à une bobine du transformateur jusqu'à obtention du flux de saturation (Rs),
puis le flux magnétique (1) est de nouveau réduit par application d'une deuxième impulsion de tension de polarité inverse et ayant une aire tension-temps définie.

**2.** Procédé selon la revendication 1, dans lequel l'aire tension-temps (1) de la deuxième impulsion de tension est sélectionnée et une troisième impulsion de tension définie ayant une polarité inversée par rapport à la deuxième impulsion de tension est appliquée consécutivement à la deuxième impulsion de tension de manière à atteindre dans le transformateur un point de fonctionnement pour lequel l'inductance différentielle du convertisseur est aussi grande que possible avec un courant de magnétisation qui est faible par rapport au courant de saturation.

**3.** Procédé selon les revendications 1 ou 2, dans lequel le courant de magnétisation correspondant au flux magnétique défini produit est déterminé dans la bobine secondaire (3) en générant un courant de magnétisation alternatif, en faisant en sorte que la séquence d'impulsions soit appliquée alternativement à une fréquence prédéterminée avec des signes respectifs inversés pour les deux polarités de saturation.

**4.** Procédé selon la revendication 3, dans lequel des cycles de mesure sont établis avec un temps de cycle (tz) qui présente au cours de chaque période un intervalle de temps contenant un temps de démagnétisation (te) et un intervalle de temps contenant un temps de mesure (tm).

5. Procédé selon la revendication 3 ou 4, dans lequel l'amplitude du courant de magnétisation alternatif obtenu est déterminée et un signal de correction dont la courbe de variation et l'amplitude correspondent à un courant alternatif de magnétisation rectangulaire est généré, et le signal de mesure est corrigé de manière correspondante selon le signal de correction déterminé.

6. Procédé selon l'une des revendications précédentes, dans lequel le signal de mesure est corrigé en vue d'un traitement ultérieur de manière à ce que tous les intervalles de temps (te) présents dans le signal de mesure, qui correspondent à un intervalle de temps d'une impulsion de tension de la séquence d'impulsions prédéterminée présentant une certaine polarité, soient dotés d'une valeur constante prédéterminée, en particulier la valeur zéro.

7. Procédé selon la revendication 6, dans lequel le signal de mesure corrigé est en outre multiplié par une fonction de fenêtre, en particulier un signal sinusoïdal à fréquence cyclique et cycliquement synchrone.

8. Procédé selon l'une des revendications précédentes, dans lequel l'amplitude de la résistance ohmique négative (Rz) générée est régulée sur la base d'une compensation incomplète ou d'une surcompensation déterminée de la résistance ohmique (Rcu) de la bobine secondaire (3).

9. Procédé selon la revendication 8, dans lequel une compensation incomplète ou une surcompensation de la résistance ohmique (Rcu) de la bobine secondaire (3) est déterminée en déterminant à partir du signal de mesure l'amplitude d'un harmonique qui se produit lorsqu'un courant de magnétisation alternatif s'écarte d'une forme d'onde rectangulaire.

10. Procédé selon l'une des revendications précédentes, dans lequel une tension de décalage se produisant dans le circuit secondaire, en particulier provoquée par des composants électroniques utilisés, est déterminée puis compensée.

11. Procédé selon la revendication 10, dans lequel la valeur de la tension de décalage est déterminée par corrélation, en déterminant à partir du signal de mesure l'amplitude d'un harmonique avec lequel un signal en dents de scie simple (Iz) est distingué d'un signal en dents de scie double Id ou d'un signal rectangulaire.

12. Procédé selon l'une des revendications précédentes, utilisé pour mesurer, dans un appareil électrique, des courants différentiels ou des courants d'erreur qui contiennent non seulement une composante de courant alternatif mais aussi une composante de courant continu.

13. Procédé selon l'une des revendications précédentes, dans lequel la bobine de solénoïde destinée à délivrer la séquence d'impulsions prédéterminée dans le noyau du transformateur est la bobine secondaire (3) du transformateur.

14. Dispositif de mesure de courants électriques comprenant au moins un transformateur de courant, destiné à être couplé aux bornes secondaires du transformateur de courant et conçu, en liaison avec le transformateur de courant, pour mettre en oeuvre le procédé de mesure selon l'une des revendications 1 à 13.

15. Dispositif selon la revendication 14, dans lequel le dispositif comporte au moins une source de tension commandable (25) et au moins un dispositif de détection de courant (10) qui sont reliés à une unité de commande.

16. Dispositif selon la revendication 15, comprenant un dipôle actif (5) qui est relié par l'intermédiaire d'un premier régulateur au dispositif de détection de courant (10) de manière à former un circuit de régulation destiné à des composantes de fréquence définies d'un signal de mesure généré par le détecteur de courant (10).

17. Dispositif selon la revendication 15 ou 16, comprenant en outre un second régulateur (6) destiné à adapter la résistance de dipôle négative (Rz) à la résistance de bobine ohmique dépendant de la température.

18. Dispositif selon la revendication 17, dans lequel le deuxième régulateur est conçu pour effectuer l'adaptation de la résistance de dipôle négative (Rz) par l'intermédiaire de coefficients de Fourier et par compensation de composantes de fréquence indésirables du signal de mesure.

**19.** Dispositif selon l'une des revendications 15 à 18, dans lequel l'unité de commande est mise en oeuvre avec un microcontrôleur.

**20.** Système de mesure de courants électriques, comprenant un transformateur de courant inductif et le dispositif selon l'une des revendications 15 à 19.

**21.** Procédé de mesure de courants électriques à l'aide d'un transformateur de courant, comprenant les étapes consistant à :

  • étendre la configuration du circuit secondaire (4) du transformateur de courant avec un dispositif électrique de manière à ce qu'un dipôle actif (5) formant une résistance ohmique négative (Rz) et à ce qu'un dispositif de détection de courant (10) présent sur le circuit secondaire (4) du transformateur soient connectés en série, qu'une source de tension (25) soit connectée en série dans le circuit électrique d'une bobine secondaire (3) du transformateur, et qu'une unité de commande soit reliée au dispositif de détection de courant (10) et à la source de tension (25) ;
  • lire le dispositif de détection de courant (10) et commander la source de tension (25) au moyen de l'unité de commande pour mettre en oeuvre le procédé selon l'une des revendications 1 à 13 ; et
  • délivrer un signal de sortie de l'unité de commande, qui contient la composante continue ainsi que la composante alternative d'un courant primaire électrique du transformateur.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005028881 B4
- DE 10237342 A1
- DE 19943802
- EP 1212821 A
- DE 3642393 A1
- DE 3543985 A1
- DE 19826410 A1
- EP 1267467 A2
- DE 3534985 A1
- DE 3543948 B1
- DE 29705030
- EP 0284472 A1